(19) **Europäisches Patentamt**

**European Patent Office**

**Office européen des brevets**

(11) **EP 1 415 952 A1**

(12) **EUROPEAN PATENT APPLICATION**
published in accordance with Art. 158(3) EPC

(43) Date of publication:
**06.05.2004 Bulletin 2004/19**

(51) Int Cl.⁷: **B82B 1/00**, B82B 3/00,
H01L 49/00, H01L 29/06

(21) Application number: **02746056.7**

(22) Date of filing: **15.07.2002**

(86) International application number:
**PCT/JP2002/007167**

(87) International publication number:
**WO 2003/016207 (27.02.2003 Gazette 2003/09)**

(84) Designated Contracting States:
**AT BE BG CH CY CZ DE DK EE ES FI FR GB GR
IE IT LI LU MC NL PT SE SK TR**
Designated Extension States:
**AL LT LV MK RO SI**

(30) Priority: **09.08.2001 JP 2001242053
06.03.2002 JP 2002060327**

(71) Applicant: **Sony Corporation
Tokyo 141-0001 (JP)**

(72) Inventors:
• **Ugajin, Ryuichi c/o Sony Corporation
Tokyo 141-0001 (JP)**
• **Matsumura, Hajime c/o Sony Corporation
Tokyo 141-0001 (JP)**
• **Mori, Yoshifumi c/o Sony Corporation
Tokyo 141-0001 (JP)**

(74) Representative: **Müller, Frithjof E., Dipl.-Ing.
Müller Hoffmann & Partner
Patentanwälte
Innere Wiener Strasse 17
81667 München (DE)**

(54) **FRACTAL STRUCTURE AND ITS PRODUCING METHOD&comma; FUNCTIONAL MATERIAL AND ITS PRODUCING METHOD&comma; AND FUNCTIONAL DEVICE AND ITS PRODUCING METHOD**

(57) A fractal structure is formed to include at least one heterojunction formed by two regions different in fractal dimension characterizing the self similarity from each other. Especially in a stellar fractal structure, the heterojunction is formed by forming a region (dendritic region) with a lower fractal dimension around a core (somatic region) with a higher fractal dimension. These two regions forming the heterojunction are different in phase from each other. For example, they are a combination of a ferromagnetic phase and a paramagnetic phase, or a combination of a metal phase and a Mott insulative phase. The fractal structure may be used to realize a functional material or a functional device.

*Fig. 54*

SOMATIC REGION / DENDRITIC REGION / SOMATIC REGION

**Description**

Technical Field

This invention relates to a fractal structure, its forming method, functional material, its forming method, functional device and its forming method especially based on a novel principle.

Background Art

When application of a solid material to electronic or optical devices is intended, physical properties of the material may restrict its applications. For example, in case the use of a semiconductor material in a light emitting device is intended, it will be usable in a device of a certain emission wavelength corresponding to the band gap of the material, but some consideration will be necessary for changing the emission wavelength. Regarding physical properties related to semiconductor bands, controls by superlattices have been realized. More specifically, by changing the period of a superlattice, the bandwidth of its subband can be controlled to design an emission wavelength.

Targeting on controlling many-electron-state structures by material designs, the Inventor proposed many-body effect engineering by quantum dot-based structures and has continued theoretical analyses ((1) U.S. Patent 5,430,309; (2) U.S. Patent 5,663,571; (3) U.S. Patent 5,719,407; (4) U.S. Patent 5,828,090; (5) U.S. Patent 5,831,294; (6) U.S. Patent 6,020,605; and (7) Physica (Amsterdam) 1E, 226(1997)). For example, realization of various correlated electronic systems is expected by adjusting a tunneling phenomenon between quantum dots and interaction between electrons in quantum dots. Let the tunneling transfer between adjacent quantum dots be written as t. Then, if quantum dots are aligned to form a tetragonal lattice, the bandwidth of one electron state is $T_{eff}$=4t. If quantum dots form a one-dimensional chain, the bandwidth of one electron state is $T_{eff}$=2t. If they form a three-dimensional quantum dot array, the bandwidth of one electron state is $T_{eff}$=6t. That is, if D is the dimension of a quantum dot array, the bandwidth of one electron state has been $T_{eff}$=2Dt. Here is made a review about half-filled (one electron per each quantum dot) Mott-Hubbard transition (also called Mott transition or Mott metal-insulator transition). Let the effective interaction of electrons within a quantum dot be written as $U_{eff}$. Then the Hubbard gap on the part of the Mott insulator is substantially described as $\Delta=U_{eff}-T_{eff}$, and the Mott transition can be controlled by changing $U_{eff}$ or t. As already proposed, the Mott-Hubbard transition can be controlled by adjusting $U_{eff}$ or t, using a field effect, and it is applicable to field effect devices (Literature (7) introduced above).

On the other hand, through a review of the equation of $\Delta=U_{eff}-T_{eff}=U_{eff}-2Dt$, it might be possible to control Mott-Hubbard transition by controlling the dimensionality D of the system. For this purpose, the Applicant already proposed a fractal complex that can continuously be changed in dimensionality, and has indicated that Mott-Hubbard transition can be controlled by changes of the fractal dimension.

To permit designs of materials in a wider range, it is desired to modify and control the dimensionality of the materials by a method transgressing the simple fractal theory.

An object the invention intends to accomplish is to provide a fractal structure, its forming method, functional material, its forming method, functional device and its forming method that can modify and control the dimensionality of a material by a design method beyond the simple fractal nature to derive new physical properties of the material.

Another object the invention intends to accomplish is to provide a fractal structure, its forming method, functional material, its forming method, functional device and its forming method that can realize heterojunctions or phase separation by a design method beyond the simple fractal nature.

Disclosure of Invention

The Inventor found, through concentrated researches toward solution of those issues, that a more complex fractal structure having heterojunctions by contact of a plurality of portions characterized by fractal dimensions can be formed by changing the growth conditions with time during growth of the fractal structure from a plurality of origins. Especially in the process of growing a random fractal, it has been found that once a region of a low fractal dimension (dendritic region) is formed around a core of a high fractal dimension (somatic region), a fractal structure in form of a nerve cell having a heterojunction between those regions can be made. Then, it has been found that, in fractal structures of this type, phase separation in a correlated electron system or phase separation in a ferromagnetic system can be realized. Further, it has been found that, in fractal structure of the same type, occurrence of phase transition, such as magnetic phase transition, and chaos, such as quantum chaos in an electron state, can be controlled. As a result of later analysis in greater detail, it has been found that there are fractal dimensions suitable for controlling these phenomena.

The term "hetero junction" herein means any junction made by contact of regions different in fractal dimension, which are made of either a common material or different materials. In the present application, such a hetero junction should be construed to contemplate both a junction with step-by-step changes in fractal dimension between two regions (stepwise junction) and a junction with spatially linear or curved continuous (or stepless) changes in fractal dimension between two regions (slanting junction). As explained later in greater detail, there is no essential difference between them from the viewpoint of deriving necessary physical properties. The latter slanting junction can be made more easily than the former stepwise junction, and therefore more advantageous for use in forming a fractal structure, functional material and functional device.

The present invention has been made on the basis of those researches by the Inventor.

That is, to overcome he above-indicated problems, the first aspect of the invention is a fractal structure comprising:

at least one heterojunction formed by two regions different in fractal dimension characterizing the self similarity from each other.

In the first aspect of the invention, those two regions forming the heterojunction are different in phase. In other words, these two regions forming the heterojunction are in phase separation. More specifically, these two regions are a combination of a ferromagnetic phase and a paramagnetic phase or a combination of a metal phase and a Mott insulator phase. Additionally, a potential barrier against conduction band electrons is formed along the heterojunction interface due to a difference in bandwidth between the conduction bands caused by the difference in fractal dimension between the two regions.

In the first aspect of the invention, the nature of the phase transition appearing in the fractal structure is controlled. Alternatively, correlation between electrons of an interacting electron system is controlled. Additionally, the magnetization curve of the ferromagnetic phase transition is controlled. Furthermore, the nature of the chaos appearing in the fractal structure is controlled, or more specifically, the quantum chaos in the electron state, for example, is controlled. Controllability of the quantum chaos in the electron state can be enhanced by introduction of a random magnetic field by addition of a magnetic impurity in addition to adjustment of the ratio of volumes occupied by respective regions in the entire fractal structure. Of course, the control of the quantum chaos in the electron state is possible solely by introduction of a random magnetic field by addition of a magnetic impurity without adjustment of the ratio of volumes occupied by respective regions in the entire fractal structure. The volume ratio of respective regions correspond to the ratio of atoms forming the respective regions, and it corresponds to the ratio of lengths of growth time (steps) required for forming these regions in an embodiment of the invention explained later in greater detail.

In the first aspect of the invention, the fractal structure typically includes a first region having a first fractal dimension and forming the core and one or more second regions encircling the first region and having a second fractal dimension lower than the first fractal dimension. When the first and second regions as a whole exhibit a stellar shape, the structure is a stellar fractal structure. In a typical example, two first regions and one interposed second region make two heterojunctions. In the fractal structure including the first and second regions, from the viewpoint of ensuring sufficient controllability of the nature of the phase transition brought about or the correlation between electrons of an interacting electron system, more specifically from the viewpoint of favorably controlling the magnetization curve of ferromagnetic phase transition, quantum chaos, or the like, or favorably controlling a correlated electron system to form a satisfactory heterojunction by a Mott insulator phase and a metal phase, or favorably controlling a ferromagnetic system to form a satisfactory heterojunction by a ferromagnetic phase and a paramagnetic phase, the first fractal dimension $D_{f1}$ and the second fractal dimension $D_{f2}$ are adjusted to satisfy $D_{f1}>2.7$ and $D_{f2}<2.3$, or typically $2.7<D_{f1}\leq3$ and $1\leq D_{f2}<2.3$, or more preferably $2.9\leq D_{f1}\leq3$ and $1\leq D_{f2}<2.3$. The upper limit 3 of $D_{f1}$ corresponds to the dimension of a three-dimensional space, and the lower limit 1 of $D_{f2}$ is necessary for ensuring connectivity in the structure.

The second aspect of the invention is a method of forming a fractal structure having at least one heterojunction formed by two regions different in fractal dimension characterizing the self similarity from each other, comprising:

growing the fractal structure from one or more origins, and changing the growth condition with time in the growth process such that different fractal dimensions are obtained.

In the second aspect of the invention, the fractal structure is grown from the start of the growth to a first point of time under a growth condition capable of obtaining the first fractal dimension and from the first point of time to a second point of time under a growth condition capable of obtaining the second fractal dimension. Then the fractal structure having the second fractal dimension lower than the first fractal dimension is formed around the first region having the first fractal dimension. The growth condition employed in an embodiment explained later is $\alpha$ of Equation (4). In actual growth, for example, in a liquid phase, the growth condition is which kind of solvent is used for the growth. In this case, regions different in fractal dimension can be formed by changing the solvent from one kind to another in the growth process.

Similarly to the first aspect of the invention, in the fractal structure including the first and second regions, from the viewpoint of ensuring sufficient controllability of the nature of the phase transition brought about or the correlation between electrons of the interacting electron system, more specifically from the viewpoint of favorably controlling the magnetization curve of ferromagnetic phase transition, quantum chaos, or the like, or favorably controlling a correlated electron system to form a satisfactory heterojunction by a Mott insulator phase and a metal phase, or favorably controlling a ferromagnetic system to form a satisfactory heterojunction by a ferromagnetic phase and a paramagnetic phase, the first fractal dimension $D_{f1}$ and the second fractal dimension $D_{f2}$ are adjusted to satisfy $D_{f1}>2.7$ and $D_{f2}<2.3$, or typically $2.7<D_{f1}\leq3$ and $1\leq D_{f2}<2.3$, or more preferably $2.9\leq D_{f1}\leq3$ and $1\leq D_{f2}<2.3$. The upper limit 3 of $D_{f1}$ corresponds to the dimension of a three-dimensional space, and the lower limit 1 of $D_{f2}$ is necessary for ensuring connectivity in the structure.

The third aspect of the invention is a functional material comprising at least as a part thereof:

a fractal structure having at least one heterojunction formed by two regions different in fractal dimension characterizing the self similarity from each other.

In the third aspect of the invention, those two regions forming the heterojunction are different in phase. In other words, these two regions forming the heterojunction are in phase separation. More specifically, these two regions are a combination of a ferromagnetic phase and a paramagnetic phase or a combination of a metal phase and a Mott insulator phase. Additionally, a potential barrier against conduction band electrons is formed along the heterojunction interface due to a difference in bandwidth between the conduction bands caused by the difference in fractal dimension between the two regions.

In the third aspect of the invention, the nature of the phase transition appearing in the fractal structure is controlled. Alternatively, correlation between electrons of the interacting electron system is controlled. Additionally, the magnetization curve of the ferromagnetic phase transition is controlled. Furthermore, the nature of the chaos appearing in the fractal structure is controlled, or more specifically, the quantum chaos in the electron state, for example, is controlled. Controllability of the quantum chaos in the electron state can be enhanced by introduction of a random magnetic field by addition of a magnetic impurity in addition to adjustment of the ratio of volumes occupied by respective regions in the entire fractal structure. Of course, the control of the quantum chaos in the electron state is possible solely by introduction of a random magnetic field by addition of a magnetic impurity without adjustment of the ratio of volumes occupied by respective regions in the entire fractal structure. The volume ratio of respective regions correspond to the ratio of atoms forming the respective regions, and it corresponds to the ratio of lengths of growth time (steps) required for forming these regions in an embodiment of the invention explained later in greater detail.

In the third aspect of the invention, the fractal structure typically includes a first region having a first fractal dimension and forming the core and one or more second regions encircling the first region and having a second fractal dimension lower than the first fractal dimension. When the first and second regions as a whole exhibit a stellar shape, the structure is a stellar fractal structure. In a typical example, two first regions and one interposed second region make two heterojunctions. In the fractal structure including the first and second regions, from the viewpoint of ensuring sufficient controllability of the nature of the phase transition brought about or the correlation between electrons of the interacting electron system, more specifically from the viewpoint of favorably controlling the magnetization curve of ferromagnetic phase transition, quantum chaos, or the like, or favorably controlling a correlated electron system to form a satisfactory heterojunction by a Mott insulator phase and a metal phase, or favorably controlling a ferromagnetic system to form a satisfactory heterojunction by a ferromagnetic phase and a paramagnetic phase, the first fractal dimension $D_{f1}$ and the second fractal dimension $D_{f2}$ are adjusted to satisfy $D_{f1}>2.7$ and $D_{f2}<2.3$, or typically $2.7<D_{f1}\leq3$ and $1\leq D_{f2}<2.3$, or more preferably $2.9\leq D_{f1}\leq3$ and $1\leq D_{f2}<2.3$. The upper limit 3 of $D_{f1}$ corresponds to the dimension of a three-dimensional space, and the lower limit 1 of $D_{f2}$ is necessary for ensuring connectivity in the structure.

The fourth aspect of the invention is a method of forming a functional material including at least as a part thereof a fractal structure having at least one heterojunction formed by two regions different in fractal dimension characterizing the self similarity from each other, comprising:

growing the fractal structure from one or more origins, and changing the growth condition with time in the growth process such that different fractal dimensions are obtained.

In the fourth aspect of the invention, the fractal structure is grown from the start of the growth to a first point of time under a growth condition capable of obtaining the first fractal dimension and from the first point of time to a second point of time under a growth condition capable of obtaining the second fractal dimension. Then the fractal structure having the second fractal dimension lower than the first fractal dimension is formed around the first region having the first fractal dimension. The growth condition employed in an embodiment explained later is $\alpha$ of Equation (4). In actual growth, for example, in a liquid phase, the growth condition is which kind of solvent is used for the growth. In this case, regions different in fractal dimension can be formed by changing the solvent from one kind to another in the growth process.

Similarly to the first aspect of the invention, in the fractal structure including the first and second regions, from the viewpoint of ensuring sufficient controllability of the nature of the phase transition brought about or the correlation between electrons of an interacting electron system, more specifically from the viewpoint of favorably controlling the magnetization curve of ferromagnetic phase transition, quantum chaos, or the like, or favorably controlling a correlated electron system to form a satisfactory heterojunction by a Mott insulator phase and a metal phase, or favorably controlling a ferromagnetic system to form a satisfactory heterojunction by a ferromagnetic phase and a paramagnetic phase, the first fractal dimension $D_{f1}$ and the second fractal dimension $D_{f2}$ are adjusted to satisfy $D_{f1}>2.7$ and $D_{f2}<2.3$, or typically $2.7<D_{f1}\leq3$ and $1\leq D_{f2}<2.3$, or more preferably $2.9\leq D_{f1}\leq3$ and $1\leq D_{f2}<2.3$. The upper limit 3 of $D_{f1}$ corresponds to the dimension of a three-dimensional space, and the lower limit 1 of $D_{f2}$ is necessary for ensuring connectivity in the structure.

In the above-summarized functional material, a fractal structure and one or more other materials are combined to form a complex by a predetermined mixture ratio or distribution, if necessary, depending upon one or more intended functions thereof.

The fifth aspect of the invention is a functional device using a fractal structure having at least one heterojunction formed by two regions different in fractal dimension characterizing the self similarity from each other.

In the fifth aspect of the invention, those two regions forming the heterojunction are different in phase. In other words, these two regions forming the heterojunction are in phase separation. More specifically, these two regions are a combination of a ferromagnetic phase and a paramagnetic phase or a combination of a metal phase and a Mott insulator phase. Additionally, a potential barrier against conduction band electrons is formed along the heterojunction interface due to a difference in bandwidth between the conduction bands caused by the difference in fractal dimension between the two regions.

In the fifth aspect of the invention, the nature of the phase transition appearing in the fractal structure is controlled. Alternatively, correlation between electrons of an interacting electron system is controlled. Additionally, the magnetization curve of the ferromagnetic phase transition is controlled. Furthermore, the nature of the chaos appearing in the fractal structure is controlled, or more specifically, the quantum chaos in the electron state, for example, is controlled. Controllability of the quantum chaos in the electron state can be enhanced by introduction of a random magnetic field by addition of a magnetic impurity in addition to adjustment of the ratio of volumes occupied by respective regions in the entire fractal structure. Of course, the control of the quantum chaos in the electron state is possible solely by introduction of a random magnetic field by addition of a magnetic impurity without adjustment of the ratio of volumes occupied by respective regions in the entire fractal structure. The volume ratio of respective regions correspond to the ratio of atoms forming the respective regions, and it corresponds to the ratio of lengths of growth time (steps) required for forming these regions in an embodiment of the invention explained later in greater detail.

In the fifth aspect of the invention, the fractal structure typically includes a first region having a first fractal dimension and forming the core and one or more second regions encircling the first region and having a second fractal dimension lower than the first fractal dimension. When the first and second regions as a whole exhibit a stellar shape, the structure is a stellar fractal structure. In a typical example, two first regions and one interposed second region make two heterojunctions. Then, for instance, by externally controlling the second region, physical connection between two first regions (for example, spin correlation) is turned ON and OFF. Temperature, for example, may be used here as a control parameter. In the fractal structure including the first and second regions, from the viewpoint of ensuring sufficient controllability of the nature of the phase transition brought about or the correlation between electrons of an interacting electron system, more specifically from the viewpoint of favorably controlling the magnetization curve of ferromagnetic phase transition, quantum chaos, or the like, or favorably controlling a correlated electron system to form a satisfactory heterojunction by a Mott insulator phase and a metal phase, or favorably controlling a ferromagnetic system to form a satisfactory heterojunction by a ferromagnetic phase and a paramagnetic phase, the first fractal dimension $D_{f1}$ and the second fractal dimension $D_{f2}$ are adjusted to satisfy $D_{f1}>2.7$ and $D_{f2}<2.3$, or typically $2.7<D_{f1}\leq3$ and $1\leq D_{f2}<2.3$, or more preferably $2.9\leq D_{f1}\leq3$ and $1\leq D_{f2}<2.3$. The upper limit 3 of $D_{f1}$ corresponds to the dimension of a three-dimensional space, and the lower limit 1 of $D_{f2}$ is necessary for ensuring connectivity in the structure.

The sixth aspect of the invention is a method of forming a functional device including at least as a part thereof a fractal structure having at least one heterojunction formed by two regions different in fractal dimension characterizing the self similarity from each other, comprising:

growing the fractal structure from one or more origins, and changing the growth condition with time in the growth process such that different fractal dimensions are obtained.

In the sixth aspect of the invention, the fractal structure is grown from the start of the growth to a first point of time under a growth condition capable of obtaining the first fractal dimension and from the first point of time to a second point of time under a growth condition capable of obtaining the second fractal dimension. Then the fractal structure having the second fractal dimension lower than the first fractal dimension is formed around the first region having the first fractal dimension. The growth condition employed in an embodiment explained later is $\alpha$ of Equation (4). In actual growth, for example, in a liquid phase, the growth condition is which kind of solvent is used for the growth. In this case, regions different in fractal dimension can be formed by changing the solvent from one kind to another in the growth process.

Similarly to the first aspect of the invention, in the fractal structure including the first and second regions, from the viewpoint of ensuring sufficient controllability of the nature of the phase transition brought about or the correlation between electrons of an interacting electron system, more specifically from the viewpoint of favorably controlling the magnetization curve of ferromagnetic phase transition, quantum chaos, or the like, or favorably controlling a correlated electron system to form a satisfactory heterojunction by a Mott insulator phase and a metal phase, or favorably controlling a ferromagnetic system to form a satisfactory heterojunction by a ferromagnetic phase and a paramagnetic phase, the first fractal dimension $D_{f1}$ and the second fractal dimension $D_{f2}$ are adjusted to satisfy $D_{f1}>2.7$ and $D_{f2}<2.3$, or typically $2.7<D_{f1}\leq3$ and $1\leq D_{f2}<2.3$, or more preferably $2.9\leq D_{f1}\leq3$ and $1\leq D_{f2}<2.3$. The upper limit 3 of $D_{f1}$ corresponds to the dimension of a three-dimensional space, and the lower limit 1 of $D_{f2}$ is necessary for ensuring connectivity in the structure.

Examples of the above-summarized functional device (or electronic device) are magnetic devices making use of ferromagnetism, switching devices making use of metal-insulator transition.

According to the invention summarized above, a fractal structure such as a stellar fractal structure including a heterojunction or phase separation formed by two regions different in fractal dimension can be obtained by changing conditions for growth of the fractal structure from one or more origins with time. Additionally, in this fractal structure, the nature of phase transition appearing in the fractal structure can be controlled by adjustment of the ratio of volumes occupied by respective regions in the entire fractal structure. Further, the controllability can be improved by optimization of fractal dimensions. By using these fractal structures, functional materials or functional devices can be realized.

Brief Description of Drawings

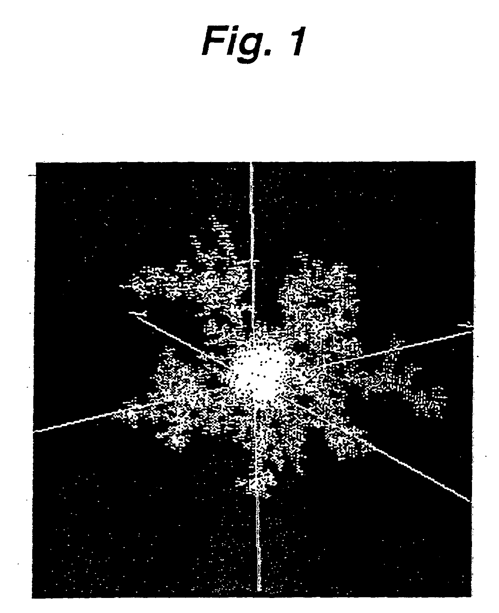

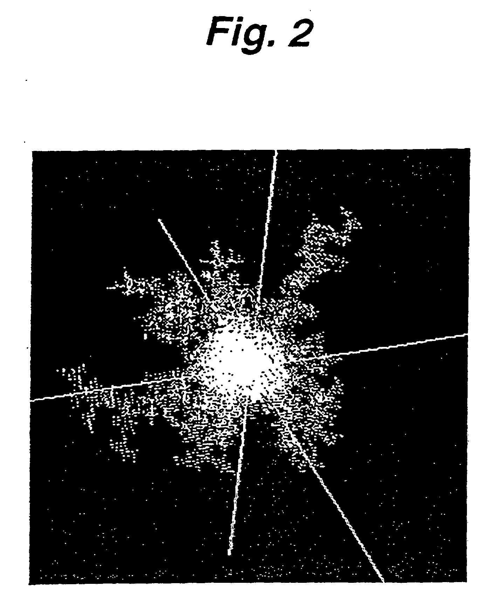

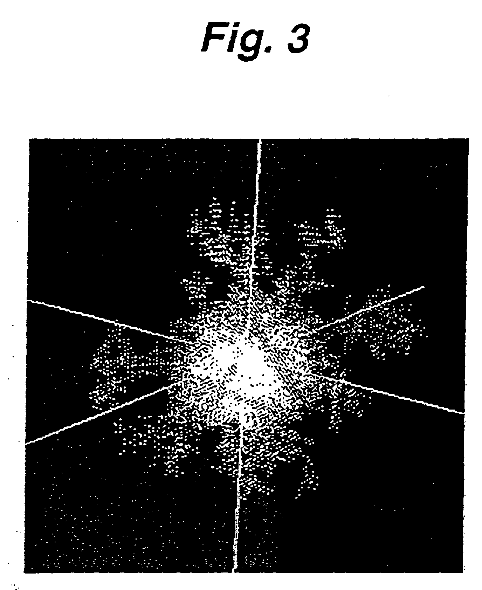

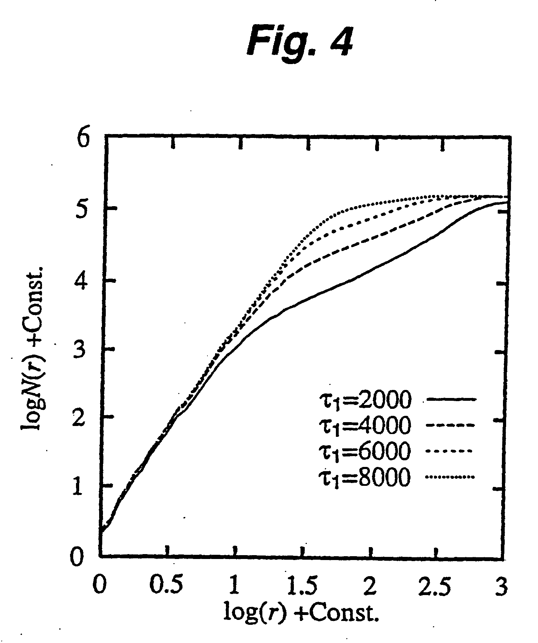

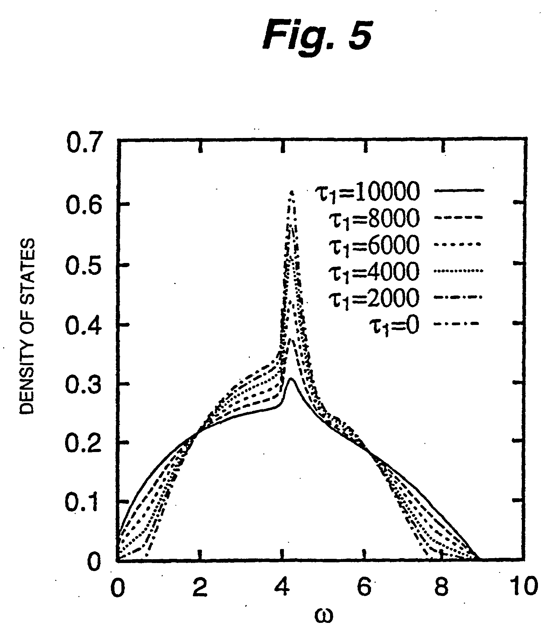

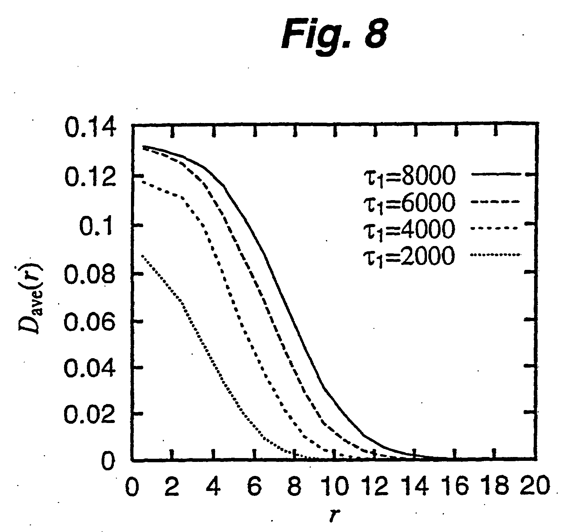

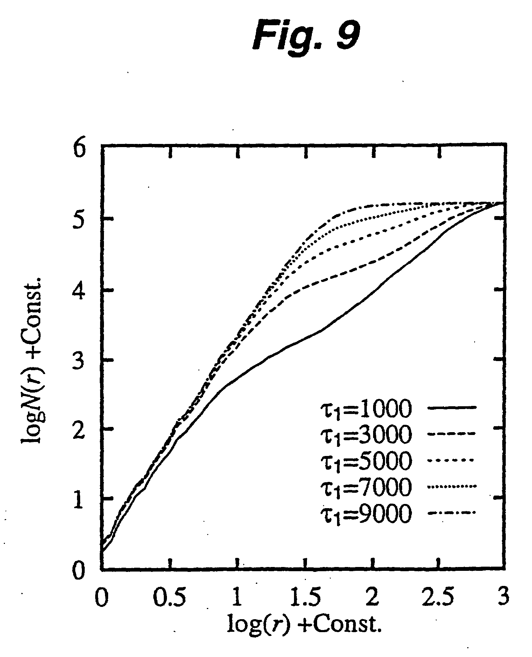

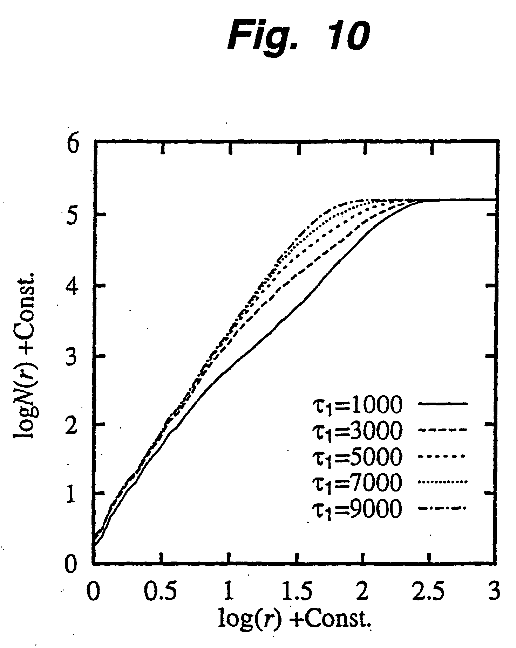

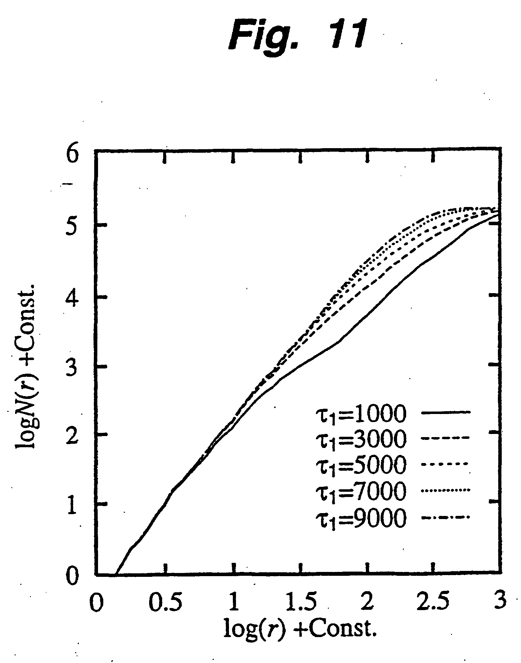

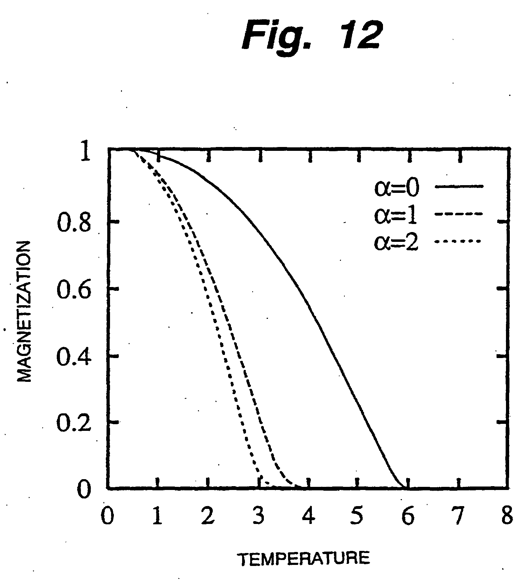

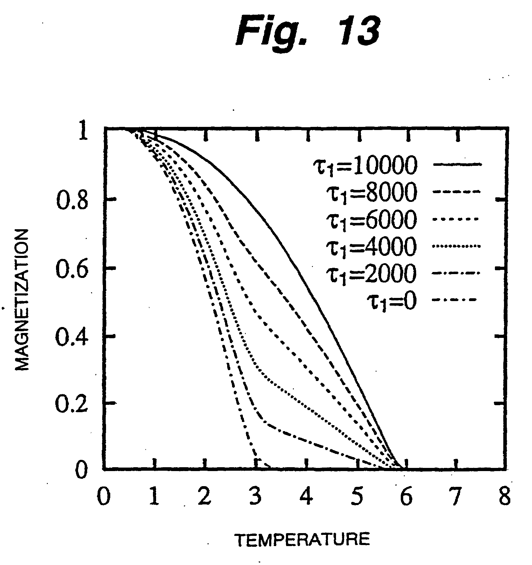

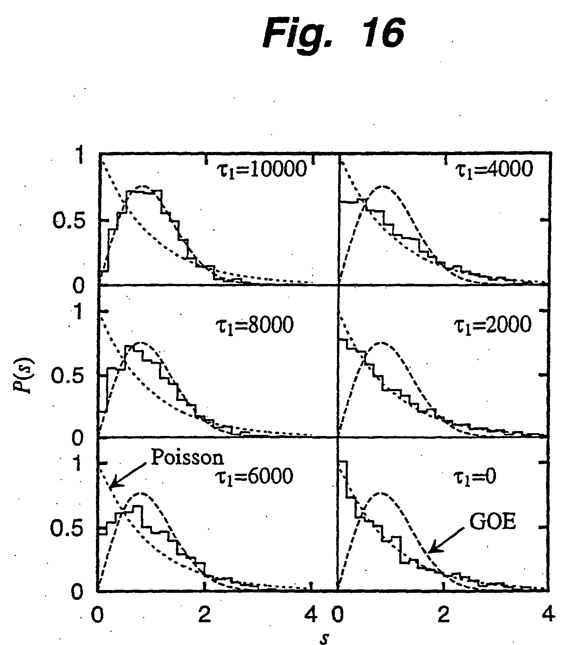

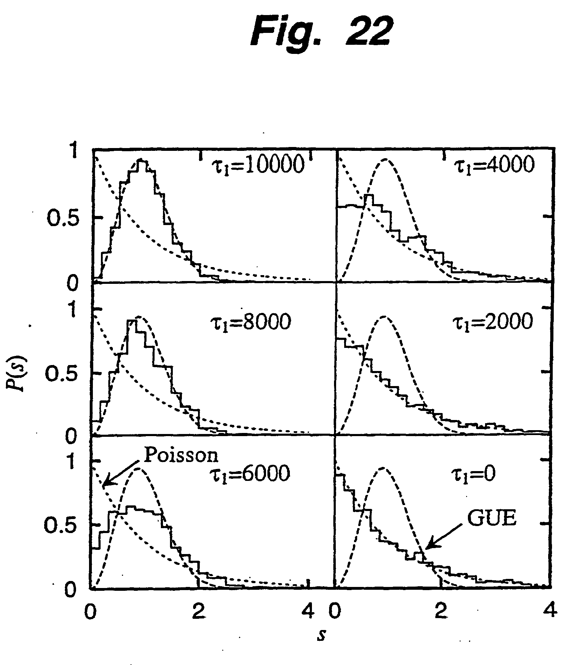

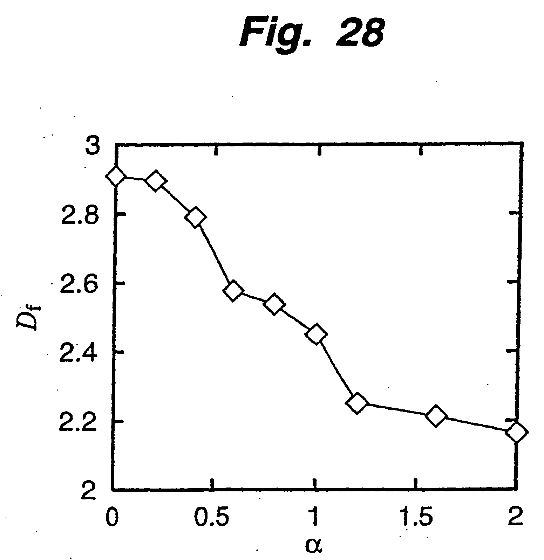

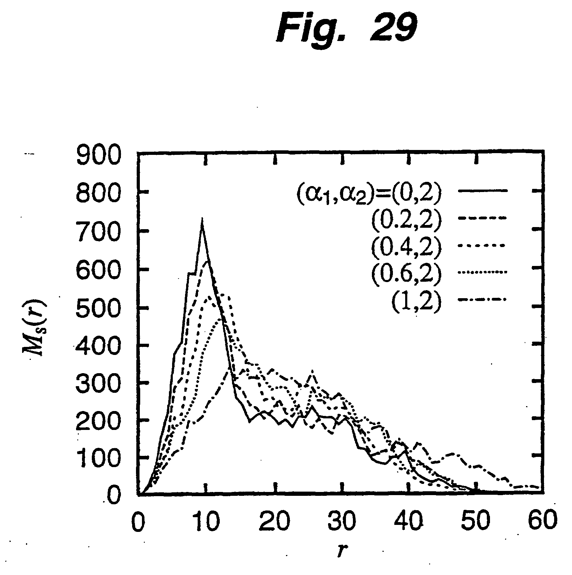

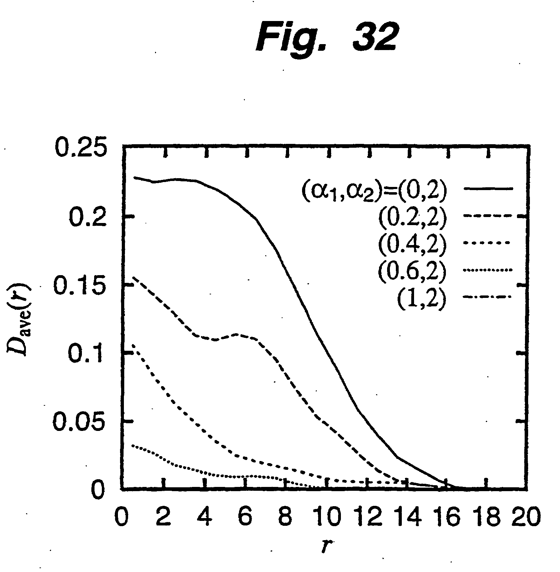

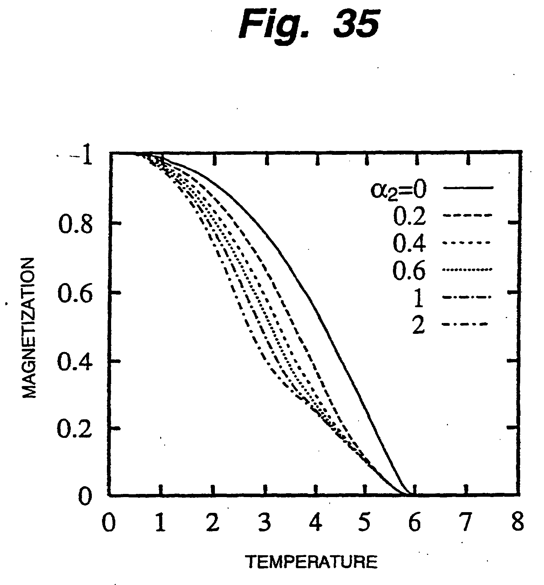

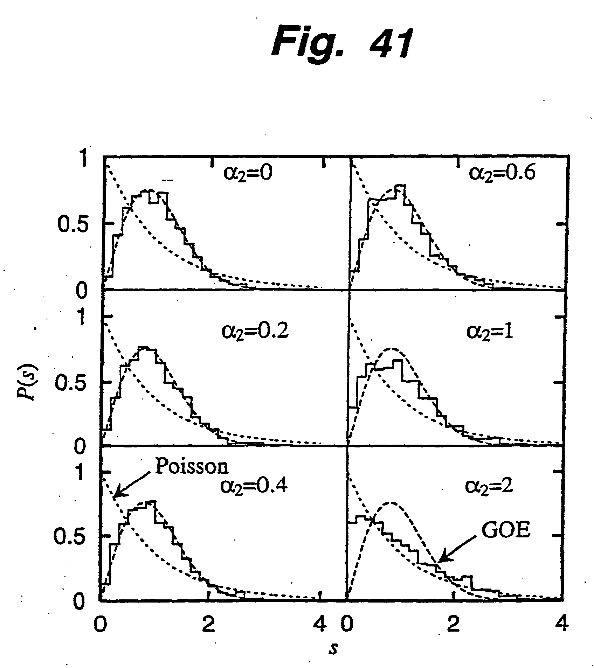

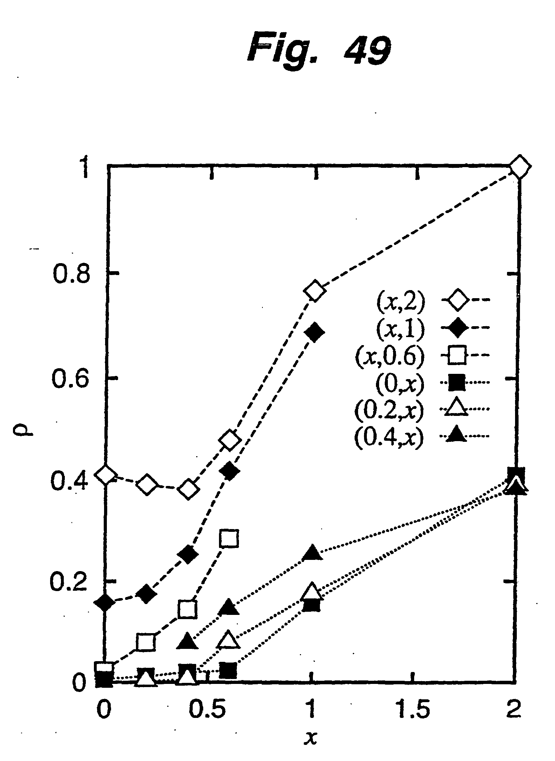

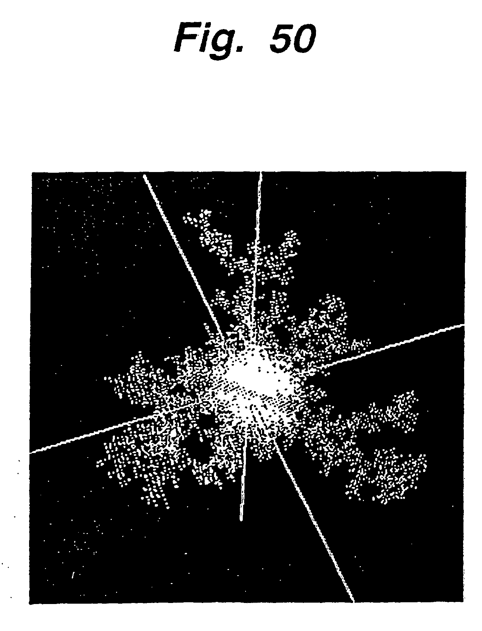

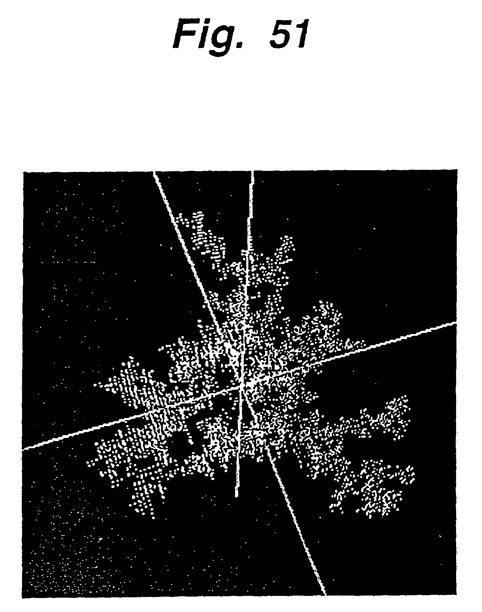

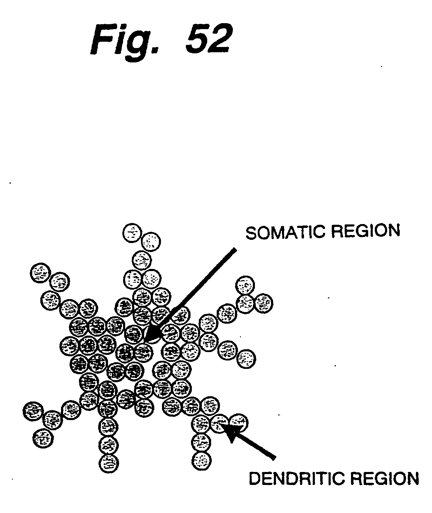

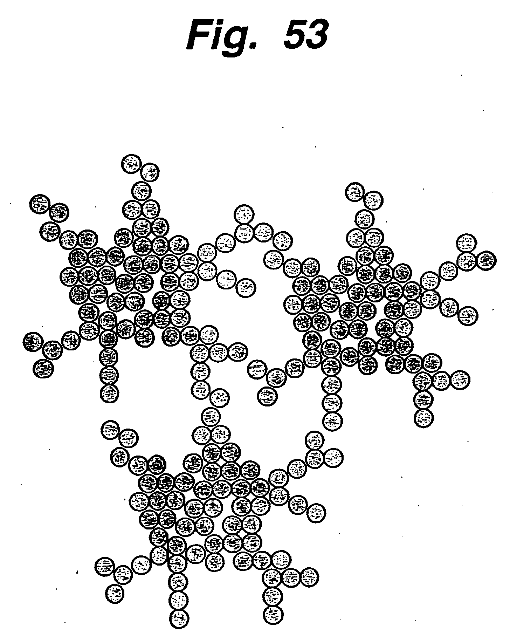

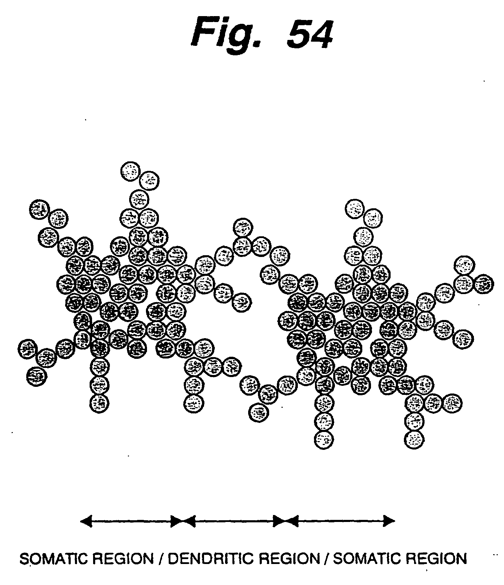

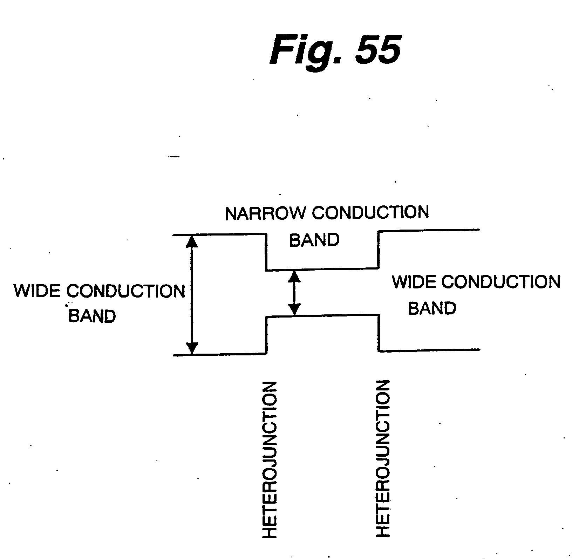

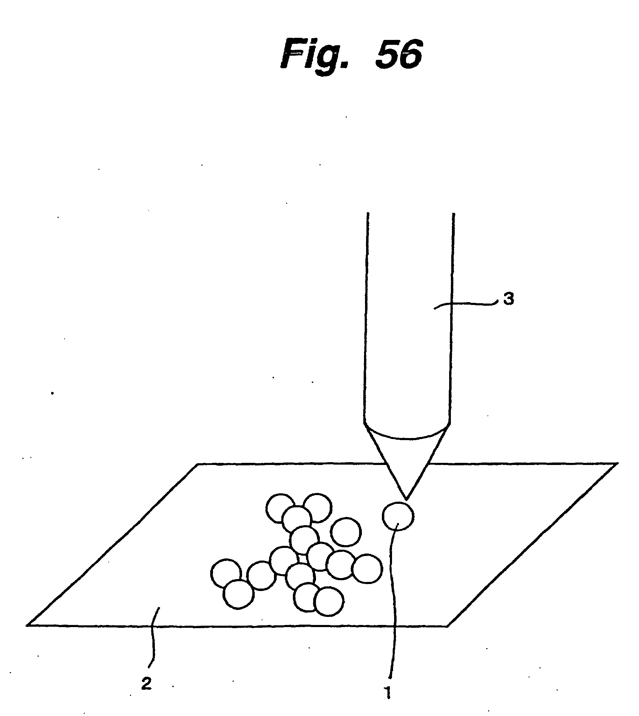

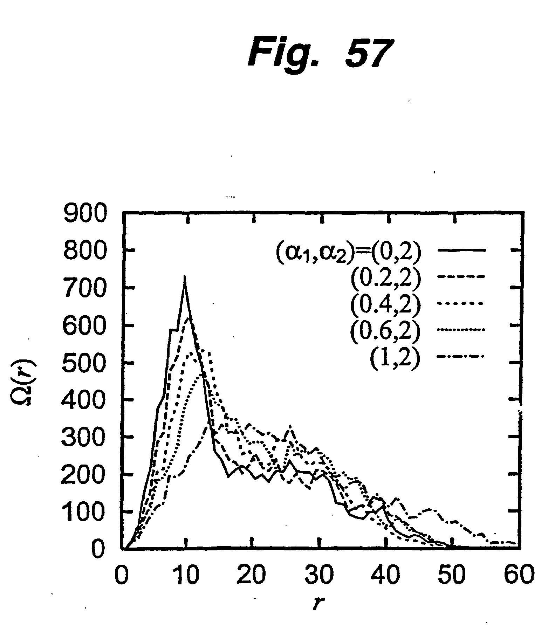

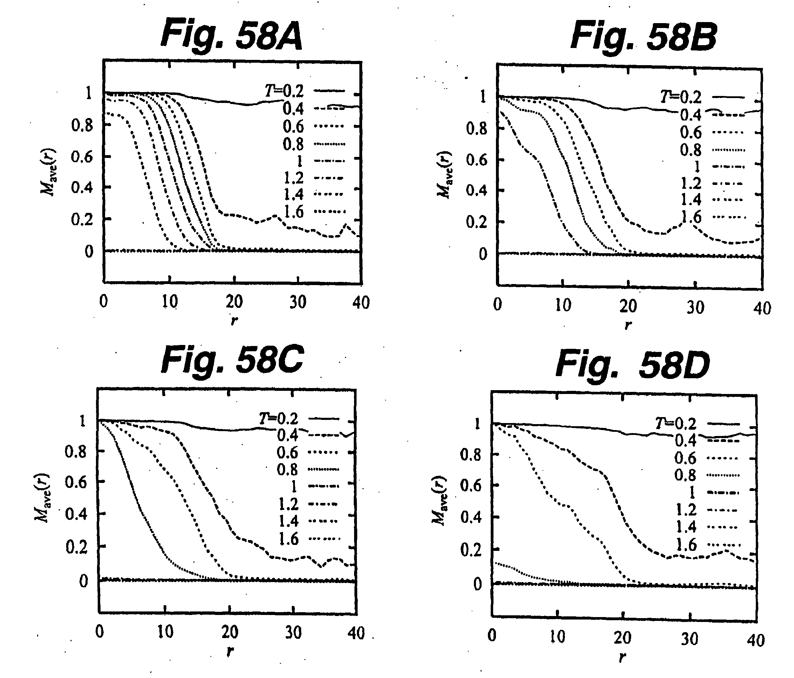

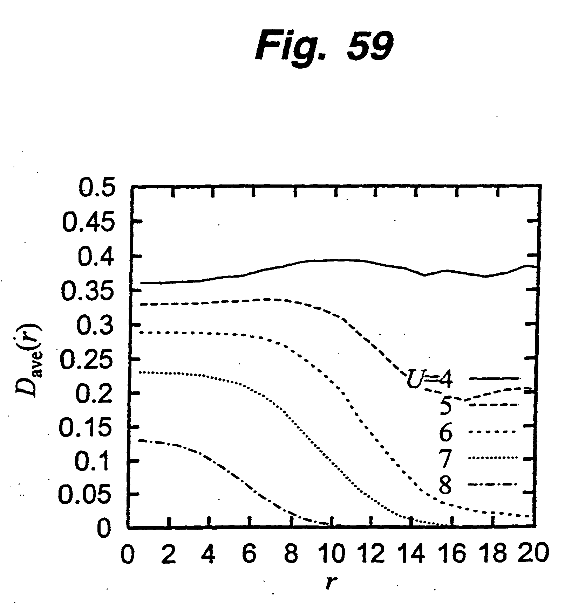

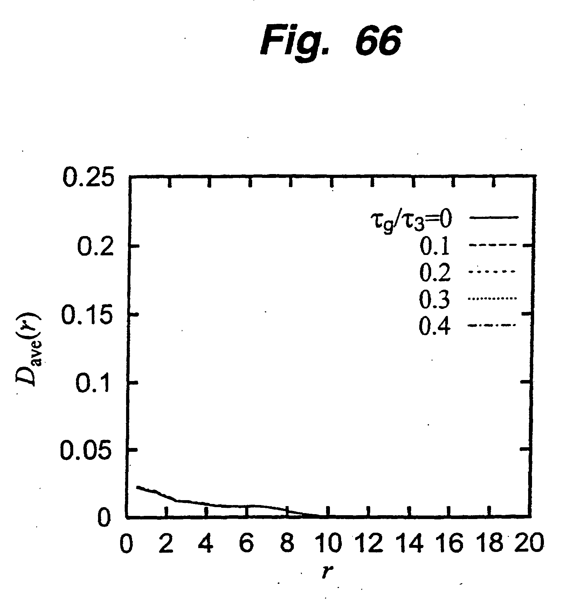

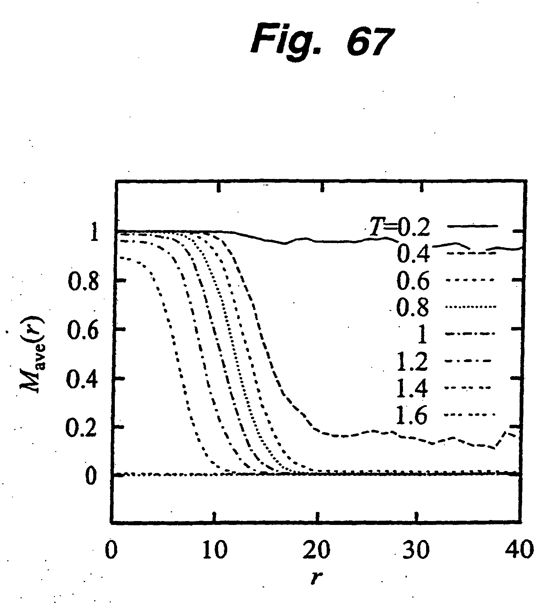

Fig. 1 and Fig. 2 are schematic diagrams showing stellar fractal structures obtained by simulation according to the first embodiment of the invention; Fig. 3 is a schematic diagram for explaining fractal dimensions in a stellar fractal structure according to the first embodiment of the invention; Fig. 4 is a schematic diagram showing log-log plotting of distance r from the origin of growth and number of growth points N(r) contained in a ball with the radius r in a stellar fractal structure according to the first embodiment of the invention; Figs. 5 through 7 are schematic diagrams showing relations between energy and density of states in a stellar fractal structure according to the first embodiment of the invention; Fig. 8 is a schematic diagram for explaining spatial changes inside a stellar fractal structure according to the first embodiment of the invention; Fig. 9 is a schematic diagram showing log-log plotting of distance r from the origin of growth and number of growth points N(r) contained in a ball with the radius r in a stellar fractal structure according to the second embodiment of the invention; Figs. 10 and 11 are schematic diagrams each showing log-log plotting of distance r from the origin of growth and number of growth points N(r) contained in a ball with the radius r in a stellar fractal structure according to the second embodiment of the invention; Fig. 12 is a schematic diagram showing spontaneous magnetization in a fractal structure having a single fractal dimension; Figs. 13 through 15 are schematic diagrams each showing spontaneous magnetization in a stellar fractal structure according to the second embodiment of the invention; Figs. 16 through 21 are schematic diagrams each showing statistics values of quantum levels in a stellar fractal structure according to the third embodiment of the invention; Figs. 22 through 27 are schematic diagrams each showing statistics values of quantum levels in a stellar fractal structure according to the fourth embodiment of the invention; Fig. 28 is a schematic diagram showing relation between $\alpha$ and fractal dimension $D_f$ in a simplex fractal structure; Figs. 29 through 31 are schematic diagrams each showing $M_s(r)$ in a stellar fractal structure according to the fifth embodiment of the invention; Figs. 32 through 34 are schematic diagrams each showing $D_{ave}$ in a stellar fractal structure according to the fifth embodiment of the invention; Figs. 35 through 40 are schematic diagrams each showing spontaneous magnetization in a stellar fractal structure according to the sixth embodiment of the invention; Figs. 41 through 48 are schematic diagrams each showing statistics values of quantum levels in a stellar fractal structure according to the seventh embodiment of the invention; Fig. 49 is a schematic diagram showing Berry-Robnik parameter $\rho$ in a stellar fractal structure according to the seventh embodiment of the invention; Fig. 50 is a schematic diagram showing a stellar fractal structure obtained by simulation according to the eighth embodiment of the invention; Fig. 51 is a schematic diagram showing a dendritic region of the stellar fractal structure shown in Fig. 50; Fig. 52 is a diagram schematically showing a stellar fractal structure according to the eighth embodiment of the invention; Fig. 53 is a diagram schematically showing a fractal structure made of stellar fractal structure according to the eighth embodiment, which are grown from a plurality of origins; Fig. 54 is a schematic diagram showing double heterojunctions formed by growing stellar fractal structures according to the eighth embodiment from a plurality of origins; Fig. 55 is a schematic diagram showing conduction bands of double heterojunctions formed by growing stellar fractal structures according to the eighth embodiment from a plurality of origins; Fig. 56 is a schematic diagram for explaining a method of fabricating the stellar fractal structure according to the eighth embodiment; Fig. 57 is a schematic diagram for explaining spatial changes of the number of growth points of a stellar fractal structure according to the eighth embodiment of the invention; Figs. 58A through 58D are schematic diagrams for explaining spatial changes of the average value of spontaneous magnetization inside the stellar fractal structure according to the eighth embodiment; Figs. 59 through 66 are schematic diagrams for explaining spatial changes inside a stellar fractal structure according to the ninth embodiment of the invention; and Figs. 67 through 74 are schematic diagrams each showing $M_{ave}(r)$ in a stellar fractal structure according to the tenth embodiment of the invention.

### Best Mode for Carrying Out the Invention

Some embodiments of the invention will now be explained below. In the following embodiments, stellar fractal structures are taken as one example of fractal structures each having portions characterized by a plurality of fractal dimensions and having a heterojunction made by two portions different in fractal dimension from each other. Each of these stellar fractal structures is in form of a nerve cell made by forming a region of a lower fractal dimension around a core of a higher fractal dimension in the growth process of random fractals.

### First Embodiment

(1) Formation of a stellar fractal structure

A method of forming the stellar fractal structure according to the first embodiment can be obtained by developing a dielectric breakdown model ((8) A. Erzan, L. Pietronero, A. Vespignani, Rev. Mod. Phys. 67, 545(1995); (9) L. Niemeyer, L. Pietronero, H.J. Wiesmann, Phys. Rev. Lett. 52, 1033(1984)).

Here is defined a tetragonal lattice S in a three-dimensional space, and a scalar potential field $\phi(i_1, i_2, i_3)$ is defined on its lattice site $(i_1, i_2, i_3) \in S$ and this is called a potential. Let this potential obey the Laplace's equation

$$\Delta\phi(i_1, i_2, i_3) = 0 \tag{1}$$

A pattern $T_n$, which will be defined hereunder, is an aggregation of lattice sites on the three-dimensional lattice. $T_0$ has (0, 0, 0) and nothing else, and $T_{n+1}$ is created by sequentially adding a single lattice site to $T_n$ according to the rule given below.

Let the potential of each site contained in $T_n$ be 1 and let the potential at infinity be 0. That is,

$$\phi(i_1, i_2, i_3) = 0 \ when \ (i_1, i_2, i_3) \to \infty \tag{2}$$

$$\phi(i_1, i_2, i_3) = 1 \ when \ (i_1, i_2, i_3) \in T_n \tag{3}$$

Under these boundary conditions, Equation (1) is solved to determine potential of individual lattice sites. The lattice site, which will be added to Tn to construct Tn+1, is not contained in $T_n$, and it is selected from the aggregation $U_n$ of lattice sites nearest to $T_n$. The number of lattice sites contained in $U_n$ is denoted by $N_n$.

Intensity of the electric field for each lattice site $(i_{1,m}, i_{2,m}, i_{3,m})$ (where m=1, 2, $\cdots$, $N_n$) contained in $U_n$ is defined as

$$E_m(\alpha) = |\phi(i_{1,m}, i_{2,m}, i_{3,m})\text{-}1|^{\alpha} \tag{4}$$

The probability that a certain site $(i_{1,m}, i_{2,m}, i_{3,m})$ in $U_n$ is selected is proportional to its electric field intensity $E_m(\alpha)$. That is, the probability is

$$p_m(\alpha) = \frac{E_m(\alpha)}{\sum_{j=1}^{N_n} E_j(\alpha)} \tag{5}$$

By repeating these operations, construction of $T_n$ is progressed. An ideal fractal will be a limited aggregation repeated infinitely as defined by

$$T_\infty = \lim_{n \to \infty} T_n \qquad\qquad (6)$$

When $\alpha=1$, the foregoing and the result of generation of the pattern by Diffusion Limited Aggregation ((10) T.A. Witten, Jr. and L.M. Sander, Phys. Rev. Lett. 47, 1400(1984); Phys. Rev. B27, 5686(1983)).

The stellar fractal structure according to the first embodiment is formed by changing the $\alpha$ parameter in accordance with the step n of the above-mentioned growth. That is, the above growth process is progressed using $\alpha_1$ under $1 \leq n \leq \tau_1$, $\alpha_2$ under $\tau_1+1 \leq n \leq \tau_2$, $\alpha_3$ under $\tau_2+1 \leq n \leq \tau_3$, and so forth. Simulation is carried out below for a fractal structure having two different fractal dimensions. Results of the simulation are shown in Figs. 1, 2 and 3. In the simulation, $\tau_2=10000$, $\alpha_1=0$ and $\alpha_2=2$ were commonly fixed, and $\tau_1$ was changed to be $\tau_1=3000$ in Fig. 1, $\tau_1=5000$ in Fig. 2, and $\tau_1=7000$ in Fig. 3. It is appreciated from Figs. 1, 2 and 3 that each structure has a ball-shaped region (somatic fractal) with a high fractal dimension at the center (growth origin) and a tree-like region (dendritic) with a lower fractal dimension around the ball-shaped region. This kind of structure often appears in nerve cells. That is, tree-like protrusions extend from the soma of a cell to perform its function.

For the purpose of understanding the structure in greater detail, a calculation process of fractal dimensions is used. Let r represent the distance from the growth origin (0, 0, 0) and let N(r) represent the number of growth points contained in a ball with the radius r. Then, using a as a factor of proportionality, if N(r) can be expressed as

$$N(r) = ar^{D_f} \qquad\qquad (7)$$

then $D_f$ is called the fractal dimension. Therefore, since logarithms of both sides are

$$\log N(r) = \log a + D_f \log r \qquad\qquad (8)$$

Then, if log-log plotting rides on a straight line, the structure can be regarded as a fractal, and its inclination is the fractal dimension. In Fig. 4, log-log plotting was carried out for various cases obtained by the above-mentioned growth experiment. It is appreciated from Fig. 4 that the plotting rides on a straight line with a large inclination when log(r) is small. When log(r) exceeds a certain critical point, the plotting rides on a straight line with a small inclination. This demonstrates that the structure has two different fractal dimensions. More specifically, in this example, the fractal dimension before log(r) exceeds the critical point is approximately 2.9, and excepting the case of $\tau_1=8000$, the fractal dimension after log(r) exceeds the critical point is approximately 2.1. Sites of the critical point increase as $\tau_1$ increases, and this supports the growth model and its interpretation.

(2) Correlated electron system in the stellar fractal structure

An electron system is defined on the stellar fractal structure defined in (1). Assume the lattice site

$$r_p = (i_{1,p} i_{2,p}, i_{3,p}) \in T_n \qquad\qquad (9)$$

that is the origin of $T_n$. In Equation (9), p=1, 2, $\cdots$, n+1. Here is defined an operator $\hat{c}^\dagger_{p,\sigma}$ that creates an electron with the spin $\sigma$ at a lattice site $r_p \in T_n$. Of course, the following anticommutative relation holds.

$$\{\hat{c}_{p,\sigma}, \hat{c}^\dagger_{q,\rho}\} = \delta_{p,q}\delta_{\sigma,\rho} \qquad\qquad (10)$$

Here the simplex band Hubbard-Hamiltonian $\hat{H}$ of this electron system is defined as

$$\hat{H} = t \sum_{i,j,\sigma} \lambda_{i,j} \hat{c}^{\dagger}_{i,\sigma} \hat{c}_{j,\sigma} + U \sum_{j} \hat{n}_{j,\uparrow} \hat{n}_{j,\downarrow} \qquad (11)$$

Assuming that electrons are movable only among nearest neighbor sites, the following is employed as $\lambda_{p,q}$.

$$\lambda_{p,q} = \begin{cases} 1 & when |r_p - r_q| = 1 \\ 0 & otherwise \end{cases} \qquad (12)$$

Additionally, the spin $\sigma$ electron density operator of the j-th site, $\hat{n}_{j,\sigma} = \hat{c}^{\dagger}_{j,\sigma} \hat{c}_{j,\sigma}$, and their sum, $\hat{n}_j = \Sigma_{\sigma} \hat{n}_{j,\sigma}$, are defined.

For the purpose of defining a temperature Green's function, here is introduced a grand canonical Hamiltonian $K = H - \mu N$ where $N = \Sigma_j n_j$. In the half-filled taken here, chemical potential is $\mu = U/2$. The half-filled grand canonical Hamiltonian can be expressed as

$$\hat{K} = t \sum_{i,j,\sigma} \lambda_{j,i} \hat{t}_{j,i,\sigma} + U/2 \sum_{i} (\hat{u}_i - 1) \qquad (13)$$

Operators $\hat{t}_{j,i,\sigma}$, $\hat{j}_{j,i,\sigma}$, $\hat{u}_i$ and $\hat{d}_{i,\sigma}$ are defined beforehand as

$$\hat{t}_{j,i,\sigma} = \hat{c}^{\dagger}_{j,\sigma} \hat{c}_{i,\sigma} + \hat{c}^{\dagger}_{i,\sigma} \hat{c}_{j,\sigma} \qquad (14)$$

$$\hat{j}_{j,i,\sigma} = \hat{c}^{\dagger}_{j,\sigma} \hat{c}_{i,\sigma} - \hat{c}^{\dagger}_{i,\sigma} \hat{c}_{j,\sigma} \qquad (15)$$

$$\hat{u}_i = \hat{c}^{\dagger}_{i,\uparrow} \hat{c}_{i,\uparrow} \hat{c}^{\dagger}_{i,\downarrow} \hat{c}_{i,\downarrow} + \hat{c}_{i,\uparrow} \hat{c}^{\dagger}_{i,\uparrow} \hat{c}_{i,\downarrow} \hat{c}^{\dagger}_{i,\downarrow} \qquad (16)$$

$$\hat{d}_{i,\sigma} = \hat{c}^{\dagger}_{i,\sigma} \hat{c}_{i,\sigma} - \hat{c}^{\dagger}_{i,\sigma} \hat{c}^{\dagger}_{i,\sigma} \qquad (17)$$

If the temperature Green function is defined for operators $\hat{A}$ and $\hat{B}$ given, taking $\tau$ as imaginary time, it is as follows.

$$\langle \hat{A}; \hat{B} \rangle = -\int_0^{\beta} d\tau \langle T_{\tau} \hat{A}(\tau) \hat{B} \rangle e^{i\omega_n \tau} \qquad (18)$$

The on-site Green function

$$G_{j,\sigma}(i\omega_n) = \langle \hat{c}_{j,\sigma}; \hat{c}^{\dagger}_{j,\sigma} \rangle \qquad (19)$$

is especially important. This is because, when analytic continuation is conducted as $i\omega_n \rightarrow \omega + i\delta$ for small $\delta$,

$$D_j(\omega) = -\mathrm{Im}\, G_j(\omega + i\delta) \qquad (20)$$

becomes the local density of states of the site j, and

$$D(\omega) = -\frac{1}{n+1}\sum_j D_j(\omega) \qquad (21)$$

becomes the density of states of the system. For later numerical calculation of densities of states, $\delta=0.0001$ will be used.

Imaginary time development of the system is obtained by the Heisenberg equation

$$\frac{d}{d\tau}\hat{A}(\tau) = [\overset{\wedge}{K},\hat{A}] \qquad (22)$$

As the equation of motion of the on-site Green function,

$$i\omega_n\left\langle \hat{c}_{j,\sigma};\hat{c}^{\dagger}_{j,\sigma}\right\rangle = 1 + t\sum_{p,j}\lambda_{p,j}\left\langle \hat{c}_{p,\sigma};\hat{c}^{\dagger}_{j,\sigma}\right\rangle + \frac{U}{2}\left\langle \hat{d}_{j,-\sigma}\hat{c}_{j,\sigma};\hat{c}^{\dagger}_{j,\sigma}\right\rangle \qquad (23)$$

is obtained. Then, the approximation shown below is introduced, following Gros ((11) C. Gros, Phys. Rev. B50, 7295 (1994)). If the site p is the nearest-neighbor site of the site j, the decomposition

$$\left\langle \hat{c}_{p,\sigma};\hat{c}^{\dagger}_{j,\sigma}\right\rangle \rightarrow t\left\langle \hat{c}_{p,\sigma};\hat{c}^{\dagger}_{p,\sigma}\right\rangle\left\langle \hat{c}_{j,\sigma};\hat{c}^{\dagger}_{j,\sigma}\right\rangle \qquad (24)$$

is introduced as the approximation. This is said to be exact in case of infinite-dimensional Bethe lattices, but in this case, it is only within approximation. Under the approximation, the following equation is obtained.

$$(i\omega_n - t^2\Gamma_{j,\sigma})G_{j,\sigma} = 1 + \frac{U}{2}\left\langle \hat{d}_{j,-\sigma}\hat{c}_{j,\sigma};\hat{c}^{\dagger}_{j,\sigma}\right\rangle \qquad (25)$$

where

$$\Gamma_{j,\sigma} = \sum_p \lambda_{p,j}G_{p,\sigma} \qquad (26)$$

was introduced. To solve the equation,

$$\left\langle \hat{d}_{j,-\sigma}\hat{c}_{j,\sigma};\hat{c}^{\dagger}_{j,\sigma}\right\rangle$$

must be analyzed. In case of half-filled models, this equation of motion is

$$i\omega_n\left\langle \hat{d}_{j,-\sigma}\hat{c}_{j,\sigma};\hat{c}^{\dagger}_{j,\sigma}\right\rangle = \frac{U}{2}G_{j,\sigma} - 2t\sum_p\lambda_{p,j}\left\langle \hat{j}_{p,j,-\sigma}\hat{c}_{j,\sigma};\hat{c}^{\dagger}_{j,\sigma}\right\rangle$$

$$+ t\sum_p\lambda_{p,j}\left\langle \hat{d}_{j,-\sigma}\hat{c}_{p,\sigma};\hat{c}^{\dagger}_{j,\sigma}\right\rangle \qquad (27)$$

Here again, with reference to the Gros theory, approximation is introduced. It is the following replacement.

$$\left\langle \hat{j}_{p,j,-\sigma}\hat{c}_{j,\sigma};\hat{c}_{j,\sigma}^{\dagger}\right\rangle \rightarrow -tG_{p,-\sigma}\left\langle \hat{d}_{j,-\sigma}\hat{c}_{j,\sigma};\hat{c}_{j,\sigma}^{\dagger}\right\rangle \qquad (28)$$

$$\left\langle \hat{d}_{j,-\sigma}\hat{c}_{p,\sigma};\hat{c}_{j,\sigma}^{\dagger}\right\rangle \rightarrow tG_{p,\sigma}\left\langle \hat{d}_{j,-\sigma}\hat{c}_{j,\sigma};\hat{c}_{j,\sigma}^{\dagger}\right\rangle \qquad (29)$$

As a result of this replacement, the following closed equation is obtained.

$$\left(i\omega_n - t^2\Gamma_{j,\sigma}\right)G_{j,\sigma} = 1 + \frac{(U/2)^2}{i\omega_n - t^2\Gamma_{j,\sigma} - 2t^2\Gamma_{j,-\sigma}}G_{j,\sigma} \qquad (30)$$

Assume here that there is no dependency on the spin. That is, assuming

$$G_{j,\uparrow} = G_{j,\downarrow} \qquad (31)$$

With regard to the stellar structure obtained in (1), its Mott transition is analyzed. In this analysis, $\tau_2$=10000, $\alpha_1$=0 and $\alpha_2$=2 were commonly fixed, and $\tau_1$ was changed as $\tau_1$=0, 2000, 4000, 6000, 8000 and 10000. Densities of states obtained by numerical calculation using t=1 are shown in Figs. 5, 6 and 7. U=8 was used in Fig. 5, U=10 in Fig. 6, and U=12 in Fig. 7. In case of $\tau_1$=10000, that is, in case of a pure fractal structure where a=0, density of states D(0) under $\omega$=0 is finite, and this electron system is in a metal phase. As $\tau_1$ decreases, D(0) decreases, and the insulative degree increases. In the range of $\tau_1$<4000, D(0) substantially disappears, Mott transition to an insulator occurs.

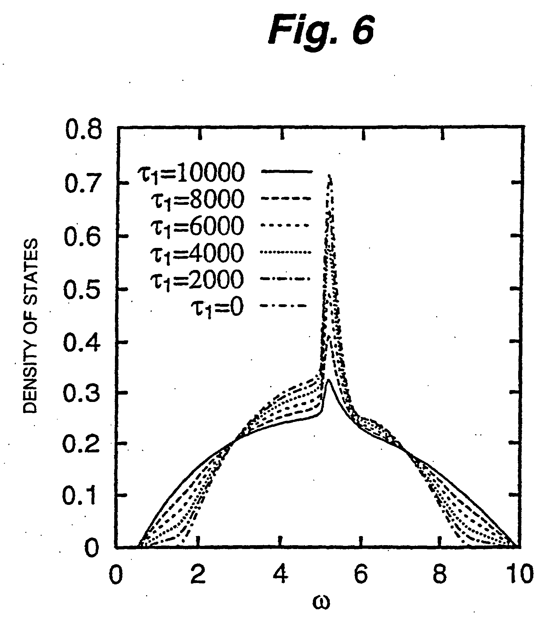

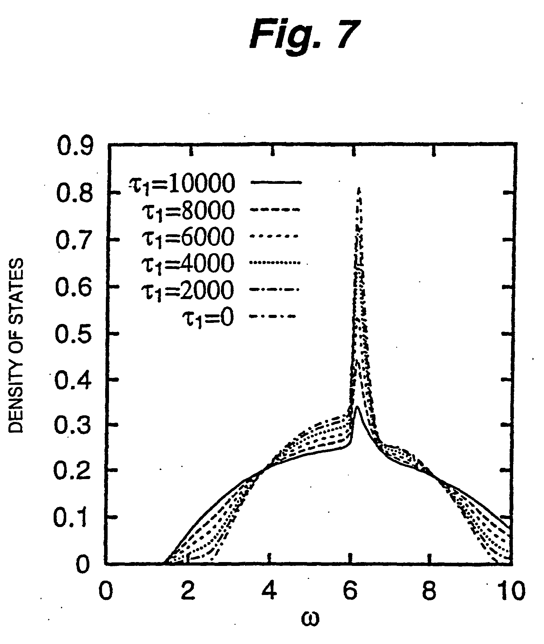

In Figs. 6 and 7, the structure behaves as a Mott insulator under every parameter. However, it is appreciated that its insulative degree, i.e. the effect of correlation among electrons, increases with $\tau_1$. This is because the effective Hubbard bandwidth increases as $\tau_1$ decreases.

Spatial changes inside the stellar fractal structure will be reviewed in detail. For this purpose, spatial changes of the local density of states $D_j(\omega=0)$ on the Fermi energy are analyzed. Let r represent the distance from the growth origin (0, 0, 0). Then, the aggregation of growth points distant from the growth origin by r to r+dr is expressed by $U_s$(r), and the original number thereof is expressed by $M_s(r)$. Then, $D_{ave}(r)$ is defined as shown below.

$$D_{ave}(r) = \frac{1}{M_s(r)}\sum_{j\in U_s(r)}D_j(0) \qquad (32)$$

This quantity is the average value of densities of states at the Fermi energy on a spherical surface at the distance r from the growth origin. Fig. 8 shows $D_{ave}(r)$ in case of U=8. In this calculation, dr=1 was used, and results for various values of $\tau_1$ were plotted. In the range with small r, i.e. in the somatic fractal region, $D_{ave}(r)$ takes finite values, and it is appreciated that the structure behaves like a metal. As r increases, $D_{ave}(r)$ decreases and gradually approaches zero. That is, Mott transition to an insulator occurs. Of course, the value of r causing Mott transition to an insulator varies, and as $\tau_1$ increases, larger and larger values of r are required because Mott metal-insulator transition can be controlled by $\alpha$ parameter. This means that a new electron system having a metal region in the center wrapped by a Mott insulator region.

Thus, it has been confirmed that the Mott metal-insulator transition appearing in the stellar fractal structure and the nature of the Mott insulator can be controlled with $\tau_1$.

Second Embodiment

(1) Formation of a stellar fractal structure

The same method as used for forming the stellar fractal structure according to the first embodiment is used here again for forming a stellar fractal structure according to the second embodiment. Numerical experiments of growth, however, were carried out also under growth conditions of $(\alpha_1, \alpha_2)=(0, 1)$ and $(\alpha_1, \alpha_2)=(1, 2)$ in addition to $(\alpha_1, \alpha_2)=(0, 2)$.

In Figs. 9 through 11, log-log plotting similar to the first embodiment are shown on the respective cases obtained by the above-mentioned growth experiments. Growth condition $(\alpha_1, \alpha_2)=(0, 2)$ was used in Fig. 9, $(\alpha_1, \alpha_2)=(0, 1)$ in Fig. 10 and $(\alpha_1, \alpha_2)=(1, 2)$ in Fig. 11. It is appreciated from Figs. 9 through 11 that the plotting rides on a straight line with a large inclination when log(r) is small. When log(r) exceeds a certain critical point, the plotting rides on a straight line with a small inclination. This demonstrates that the structure has two different fractal dimensions. Sites of the critical point increase as $\tau_1$ increases, and this supports the growth model and its interpretation.

(2) Ferromagnetic transition in the stellar fractal structure

A spin system describing a ferromagnetic structure is defined on the stellar fractal structure defined in (1). Assume the lattice site

$$r_p = (i_{1,p}, i_{2,p}, i_{3,p}) \in T_n \qquad (33)$$

that is the origin of $T_n$. In this Equation, p=1, 2, $\cdots$, n+1. By placing a spin on a lattice site $r_p \in T_n$, here is taken a spin system that can be described by the following Hamiltonian.

$$H = -\sum_{p,q} J_{p,q} S_p \cdot S_q \qquad (34)$$

$S_p$ is the spin at the p site. The following is a natural model of spin-to-spin interaction $J_{p,q}$.

$$J_{p,q} = \begin{cases} 1 & when |r_p - r_q| = 1 \\ 0 & otherwise \end{cases} \qquad (35)$$

That is, spin-to-spin interaction exists only between nearest-neighbor sites. For the purpose of calculating spontaneous magnetization M at a finite temperature T, statistical mechanics of an equilibrium system is introduced. A partition function Z is defined as follows.

$$Z = \sum_{\{S_p\}} e^{-H/T} \qquad (36)$$

where $\{S_p\}$ denotes the sum for all spin states. Spontaneous magnetization is defined as the statistical average of spins as follows.

$$M = \frac{1}{n+1} \sum_{p=1}^{n+1} \langle S_p \rangle \qquad (37)$$

where the expected value $\langle S_p \rangle$ is

$$\langle S_p \rangle = \frac{1}{Z} \sum_{\{S_p\}} S_p e^{-H/T} \qquad (38)$$

and n+1 is the total number of spins. In general, $M$ is a vector quantity in a spin space, but its absolute value $M=|M|$ is calculated.

Here is made a review about an Ising model. In an Ising model, only two states of

$$S_p = 1 \text{ or } -1 \tag{39}$$

can exist. Let the average field approximation be introduced into the Ising model. Spontaneous magnetization of the p-th site is written as $\mu_p$. In this system, since the molecule field varies with site, let it be written as $\bar{\mu}_p$. As an assumption of the average field approximation, here is employed a molecule field that can be written by spontaneous magnetization of the nearest-neighbor site as

$$\bar{\mu}_p = \sum_q J_{p \cdot q} \mu_q \tag{40}$$

This assumption simplifies the foregoing Hamiltonian to

$$H_{MF} = -\sum_{p=1}^{n+1} \bar{\mu}_p \sigma_p \tag{41}$$

When deriving a self-consistent equation ensuring spontaneous magnetization obtained by using a partition function by the simplified Hamiltonian becomes $\mu_p$,

$$\mu_p = \tanh(\beta \bar{\mu}_p) \tag{42}$$

is obtained, and by numerically solving this equation, the following spontaneous magnetization of the system is determined.

$$M_{J \sin g} = \frac{1}{n+1} \sum_{j=0}^{n} \mu_j \tag{43}$$

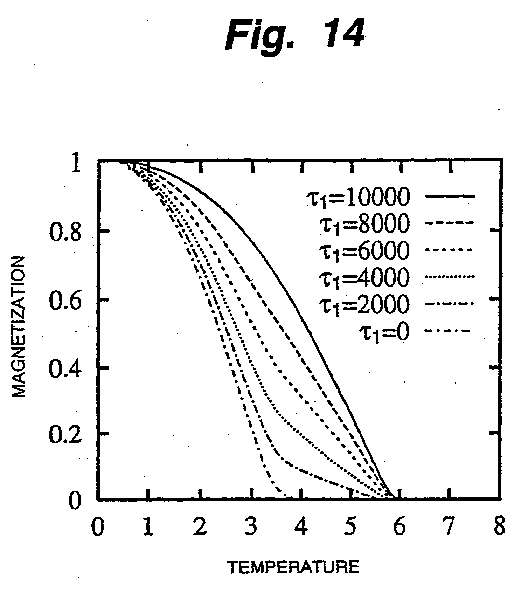

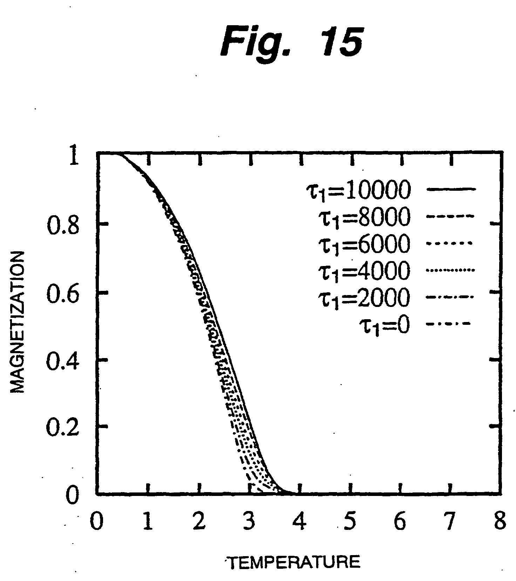

Fig. 12 shows spontaneous magnetization in a typical fractal structure having a simplex fractal dimension. Here are shown the results of $\alpha=0$, $\alpha=1$ and $\alpha=2$. Now, spontaneous magnetization in the stellar fractal structure is shown. Figs. 13 through 15 show spontaneous magnetization in the stellar fractal structure under the condition $(\alpha_1, \alpha_2)=(0, 2)$ in Fig. 13, $(\alpha_1, \alpha_2)=(0, 1)$ in Fig. 14 and $(\alpha_1, \alpha_2)=(1, 2)$ in Fig. 15, respectively. Fig. 13 is carefully reviewed hereunder. In case of $\tau_1=0$, the structure is identical to the simple fractal structure of $\alpha=2$. In case of $\tau_1=10000$, the structure is identical to the simple fractal structure of $\alpha=0$. When intermediate values between those two limits are sequentially taken, a new magnetization curve intervening these two limits appears. Of course, the magnetization curve is similar to the weighted average of these two limits. Actually, however, there is interaction between the region of $\alpha=2$ and the region of $\alpha=0$, and the entire structure forms a new magnetic structure. In Fig. 14 as well, a new magnetization curve intervening the simple fractal structures of $\alpha=1$ and $\alpha=0$ appears. In Fig. 15, a new magnetization curve intervening the simple fractal structures of $\alpha=2$ and $\alpha=1$ appears. Therefore, it has been confirmed that various materials exhibiting various aspects of magnetism can be obtained by using the stellar fractal structure that is a fractal-based complex.

Third Embodiment

(1) Formation of a stellar fractal structure

The same method as used for forming the stellar fractal structure according to the first embodiment is used here again for forming a stellar fractal structure according to the third embodiment. Numerical experiments of growth, however, were carried out also under growth conditions of $(\alpha_1, \alpha_2)=(0, 1)$ and $(\alpha_1, \alpha_2)=(1, 2)$ in addition to $(\alpha_1, \alpha_2)=(0, 2)$, similarly to the second embodiment. Results of log-log plotting for respective samples obtained by the growth experiment are substantially identical to those shown in Figs. 9 through 11.

(2) Electron system on the stellar fractal structure

Let a quantum system of a single particle be defined on the stellar fractal structure defined in (1). Assume a lattice site shown below, which is the origin of $T_n$

$$r_p = (i_{1,p}, i_{2,p}, i_{3,p}) \in T_n \tag{44}$$

where p=1, 2, ···, n. Here is defined an operator $\hat{c}_p^\dagger$ that creates a quantum at a lattice site $r_p \in T_n$. Of course, the anticommutative relation shown below holds.

$$\left\{ \hat{c}_p, \hat{c}_q^\dagger \right\} = \delta_{p,q} \tag{45}$$

Here is defined the Hamiltonian $\hat{H}$ as shown below.

$$\hat{H}_n = -\sum_{p,q} t_{p,q} \hat{c}_p^\dagger \hat{c}_q \tag{46}$$

Here is employed the following transfer $t_{p,q}$.

$$t_{p,q} = \begin{cases} 1 & when \left| r_p - r_q \right| = 1 \\ 0 & otherwise \end{cases} \tag{47}$$

In this model, hopping is possible only between nearest-neighbor sites.
When $\varepsilon_m$ denotes the eigenenergy of the Hamiltonian $\hat{H}$ and $|m\rangle$ denotes the eigenvector, they are in the following relation

$$\hat{H}|m\rangle = \varepsilon_m |m\rangle \tag{48}$$

where m=0, 1, 2, ···, n.
First, n+1 quantum levels $\varepsilon_m$ are standardized such that spacing between nearest-neighbor levels becomes 1 in average. That is,

$$\omega_j = \varepsilon_j - \varepsilon_{j-1} \tag{49}$$

However, when j=1, 2, ···, n, by using

$$\overline{\omega} = \frac{1}{n} \sum_{j=1}^{n} \omega_j \tag{50}$$

it is converted to new levels

$$\varepsilon_0 = 0 \tag{51}$$

$$\varepsilon_m = \frac{1}{\overline{\omega}} \sum_{j=1}^{m} \omega_j = \sum_{j=1}^{m} \Omega_j \tag{52}$$

In this case,

$$\Omega_j = \frac{\omega_j}{\overline{\omega}} \tag{53}$$

The density of states of the system is defined by

$$\rho(\varepsilon) = \frac{1}{n+1} \sum_{m=1}^{n+1} \delta(\varepsilon - \varepsilon_m) \tag{54}$$

and the staircase function

$$\lambda(\varepsilon) = \int_{-\infty}^{\varepsilon} d\eta \, \rho(\eta) \tag{55}$$

is calculated. The staircase function obtained is converted by a technique called "unfolding" such that the density of states becomes constant in average. By using quantum levels obtained in this manner, nearest-neighbor level-to-level spacing distribution P(s) and $\Delta_3$ statistics of Dyson and Metha are calculated as quantum level statistics values. As taught in literatures ((12) L.E. Reichl, The transition to chaos: in conservative classical systems: quantum manifestations (Springer, New York, 1992); and (13) F. Haake, Quantum Signatures of chaos, (Springer-Verlag, (1991)), by using these statistics values, it can be detected whether quantum chaos has been generated or not. It is known as well that a quantum chaotic system is sensitive to external perturbation similarly to the classical chaotic system, and analysis of quantum chaos is important as a polestar of designs of non-linear materials.

In case of an integrable system, nearest-neighbor level spacing distribution P(s) and $\Delta_3$ statistics value are those of Poisson distribution shown below

$$P_P(s) = e^{-s} \tag{56}$$

$$\Delta_3(n) = \frac{n}{15} \tag{57}$$

In case of a quantum chaotic system, it becomes GOE (Gaussian orthogonal ensemble) distribution

$$P_{GOE}(s) = \frac{\pi s}{2} e^{-\pi s^2/4} \tag{58}$$

$$\Delta_3(n) = \frac{1}{\pi^2} \left[ \log(2\pi n) + \gamma - \frac{\pi^2}{8} - \frac{5}{4} \right] + O(n^{-1}) \tag{59}$$

where $\gamma$ is the Euler's constant.

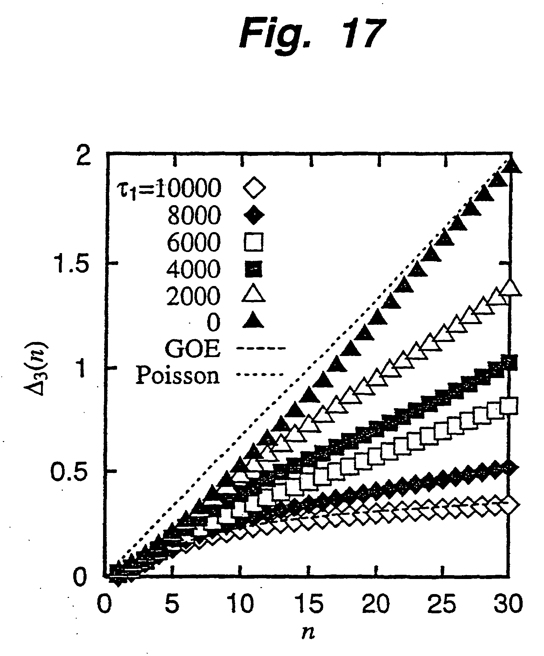

Since the stellar fractal structure analyzed here is one obtained by growth experiment of n=10000, this quantum system includes n+1=10001 eigenstates. Among them, based on energy eigenvalues concerning 1501 states from the 501-th to 2001-th eigenstates from the ground state, quantum level statistics values shown below were calculated. Figs. 16 and 17 show quantum level statistics in a stellar fractal structure of $(\alpha_1, \alpha_2)$=(0, 2). Fig. 16 shows P(s) whereas Fig. 17 shows $\Delta_3$ statistics values. In case of $\tau_1$=10000, the structure is identical to the simple fractal of $\alpha$=0, and the fractal dimension is near 3($D_f \sim 2.91$). Therefore, the system behaves as a quantum chaotic system. In this case, the quantum level statistics is that of GOE distribution. On the other hand, in case of $\tau_1$=0, the structure is identical to the simple fractal of $\alpha$=2, and the fractal dimension is near 2($D_f \sim 2.16$). Therefore, the system behaves as an integrable system. Then, as $\tau_1$ increases from 0 to 10000, the quantum level statistics changes from Poisson distribution to GOE distribution. Therefore, a wide variety of quantum systems from quantum chaotic systems to integrable systems can be realized by adjusting $\tau_1$ at predetermined values.

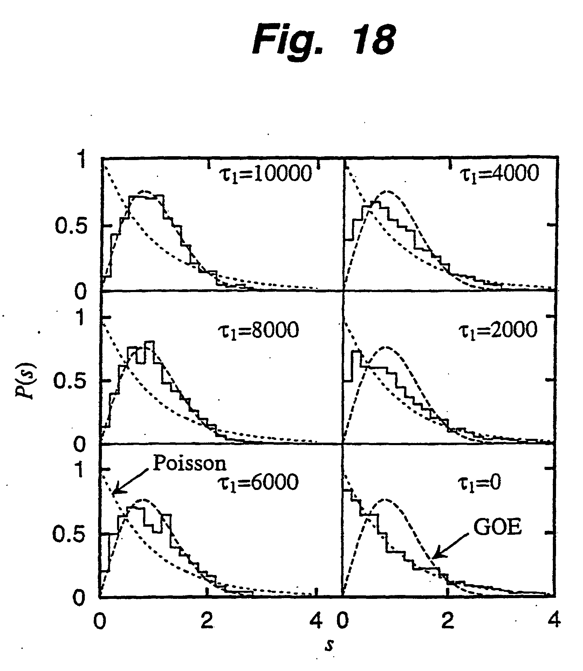

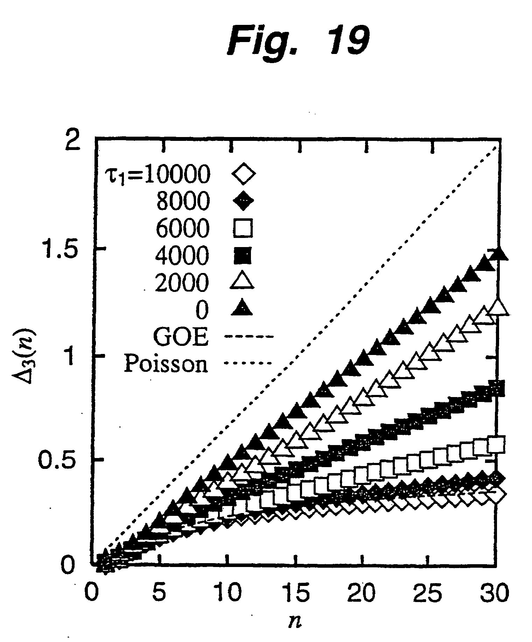

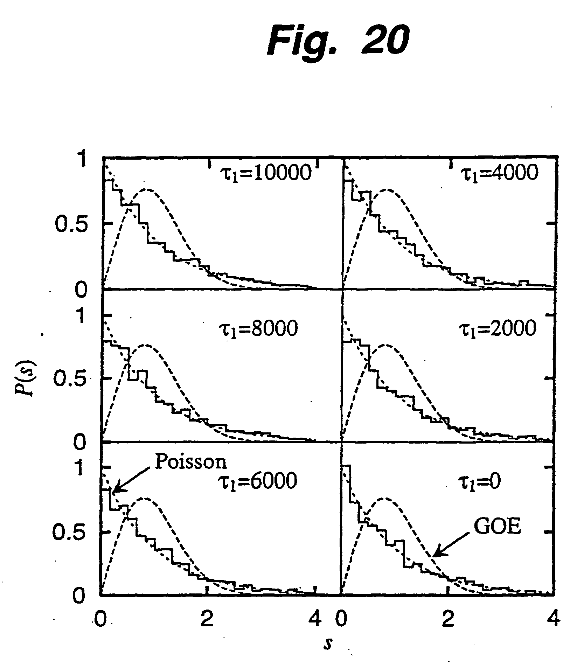

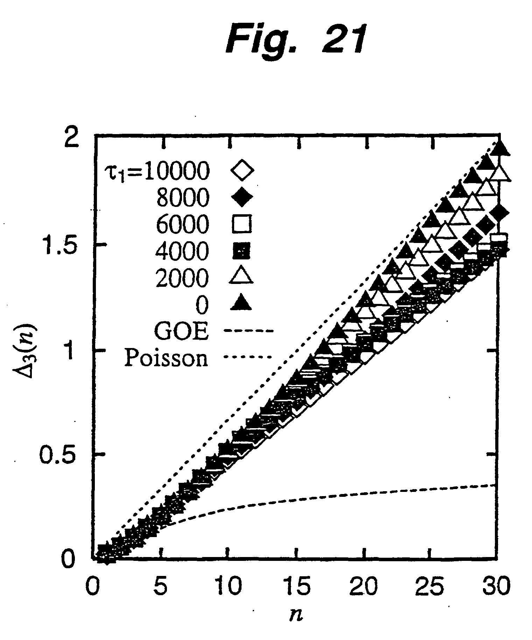

The foregoing example was a stellar fractal structure in which both $\alpha$=0 and $\alpha$=2 exist together. On the other hand, since the fractal dimension of the simple fractal structure of $\alpha$=1 is approximately ($D_f \sim 2.45$), it is even possible to connect the quantum chaotic system of $\alpha$=0 and the integrable system of $\alpha$=2. Figs. 18 and 19 show quantum level statistics in a stellar fractal structure of $(\alpha_1, \alpha_2)$=(0, 1). Figs. 20 and 21 show quantum level statistics in a stellar fractal structure of $(\alpha_1, \alpha_2)$=(1, 2). Among these figures, Figs. 18 and 20 show P(s) whereas Figs. 19 and 21 show $\Delta_3$ statistics values. $\tau_1$=10000 of Figs. 18 and 19 is a quantum chaotic system identical to $\tau_1$=10000 shown in Figs. 16 and 17. It is appreciated from Figs. 16 and 17 that, as $\tau_1$ decreases, the quantum level statistics value changes from that of GOE distribution to that of Poisson distribution. However, even under $\tau_1$=0 of Figs. 18 and 19, that is, in the simple fractal of $\alpha$=1, it does not become the complete Poisson distribution. Now turn the attention to Figs. 20 and 21. $\tau_1$=10000 of Figs. 20 and 21 is identical to $\tau_1$=0 of Figs. 18 and 19, and it is the quantum level statistics value in the simple fractal structure of $\alpha$=1. As $\tau_1$ decreases, the quantum level statistics value changes toward that of Poisson distribution, and in the range where $\tau_1$ is sufficiently small, it gradually approaches that of Poisson distribution. Of course, $\tau_1$=0 in Figs. 20 and 21 is the quantum level statistics value in the simple fractal of $\alpha$=2, and it is identical to $\tau_1$=0 of Figs. 16 and 17.

Fourth Embodiment

(1) Formation of a stellar fractal structure

The same method as used for forming the stellar fractal structure according to the first embodiment is used here again for forming a stellar fractal structure according to the fourth embodiment. Numerical experiments of growth, however, were carried out also under growth conditions of $(\alpha_1, \alpha_2)$=(0, 1) and $(\alpha_1, \alpha_2)$=(1, 2) in addition to $(\alpha_1, \alpha_2)$=(0, 2), similarly to the second embodiment. Results of log-log plotting for respective samples obtained by the growth experiment are substantially identical to those shown in Figs. 9 through 11.

(2) Electron system on the stellar fractal structure

Let a quantum system of a single particle be defined on the stellar fractal structure defined in (1). Assume a lattice site shown below, which is the origin of $T_n$

$$r_p = (i_{1,p}, i_{2,p}, i_{3,p}) \in T_n \tag{60}$$

where p=1, 2, $\cdots$, n. Here is defined an operator $\hat{c}_p^\dagger$ that creates a quantum at a lattice site $r_p \in T_n$. Of course, the anticommutative relation shown below holds.

$$\{\hat{c}_p, \hat{c}_q^\dagger\} = \delta_{p,q} \tag{61}$$

Here is defined the Hamiltonian $\hat{H}$ as shown below.

$$\hat{H}_n = -\sum_{p,q} t_{p,q} \hat{C}_p^\dagger \hat{C}_q \tag{62}$$

Here is employed the following transfer $t_{p,q}$.

$$t_{p,q} = \begin{cases} \exp(i\theta_{p,q}) & \text{when} |r_p - r_q| = 1 \\ 0 & \text{otherwise} \end{cases} \qquad (63)$$

where $\theta_{p,q} = -\theta_{p,q}$ is a random real number satisfying

$$0 < \theta_{p,q} < 2\pi \qquad (64)$$

In this model, hopping is possible only between nearest-neighbor sites. Concurrently with the hopping, phase factors $\theta_{p,q}$ that are random from one site to another are added. Once the phase factors are integrated in the loop making one turn around a lattice point, a magnetic flux passing through the loop is obtained. This means that a magnetic field has been introduced locally to the random distribution of $0<\theta_{p,q}<2\pi$. This magnetic field is absolutely random both in intensity and in direction, and in spatial average, it becomes a zero magnetic field and never breaks the fractal nature of the system.

When $\varepsilon_m$ represents the eigenenergy of the Hamiltonian $\hat{H}$ and $|m\rangle$ represents the eigenvector, they are in the following relation

$$\hat{H}|m\rangle = \varepsilon_m|m\rangle \qquad (65)$$

where m=0, 1, 2, ···, n.

First, n+1 quantum levels $\varepsilon_m$ are standardized such that spacing between nearest-neighbor levels becomes 1 in average. That is,

$$\omega_j = \varepsilon_j - \varepsilon_{j-1} \qquad (66)$$

However, when j=1, 2, ···, n, by using

$$\overline{\omega} = \frac{1}{n} \sum_{j=1}^{n} \omega_j \qquad (67)$$

it is converted to new levels

$$\varepsilon_0 = 0 \qquad (68)$$

$$\varepsilon_m = \frac{1}{\overline{\omega}} \sum_{j=1}^{m} \omega_j = \sum_{j=1}^{m} \Omega_j \qquad (69)$$

In this case,

$$\Omega_j = \frac{\omega_j}{\overline{\omega}} \qquad (70)$$

The density of states of the system is defined by

$$\rho(\varepsilon) = \frac{1}{n+1} \sum_{m=1}^{n+1} \delta(\varepsilon - \varepsilon_m) \qquad\qquad (71)$$

and the staircase function

$$\lambda(\varepsilon) = \int_{-\infty}^{\varepsilon} d\eta\, \rho(\eta) \qquad\qquad (72)$$

is calculated. The staircase function obtained is converted by a technique called "unfolding" such that the density of states becomes constant in average. By using quantum levels obtained in this manner, nearest-neighbor level-to-level spacing distribution P(s) and $\Delta_3$ statistics of Dyson and Metha are calculated as quantum level statistics values. As taught in literatures ((12) L.E. Reichl, The transition to chaos: in conservative classical systems: quantum manifestations (Springer, New York, 1992); and (13) F. Haake, Quantum Signatures of chaos, (Springer-Verlag, (1991)), by using these statistics values, it can be detected whether quantum chaos has been generated or not. It is known as well that a quantum chaotic system is sensitive to external perturbation similarly to the classical chaotic system, and analysis of quantum chaos is important as a polestar of designs of non-linear materials.

In case of an integrable system, nearest-neighbor level spacing distribution P(s) and $\Delta_3$ statistics value are those of Poisson distribution shown below

$$P_P(s) = e^{-s} \qquad\qquad (73)$$

$$\Delta_3(n) = \frac{n}{15} \qquad\qquad (74)$$

In case of a quantum chaotic system under a magnetic field, it becomes GUE (Gaussian unitary ensemble) distribution

$$P_{GUE}(s) = \frac{32 s^2}{\pi^2} e^{-4 s^2 / \pi} \qquad\qquad (75)$$

$$\Delta_3(n) = \frac{1}{2\pi^2}\left[\log(2\pi n) + \gamma - \frac{5}{4}\right] + O(n^{-1}) \qquad\qquad (76)$$

where $\gamma$ is the Euler's constant.

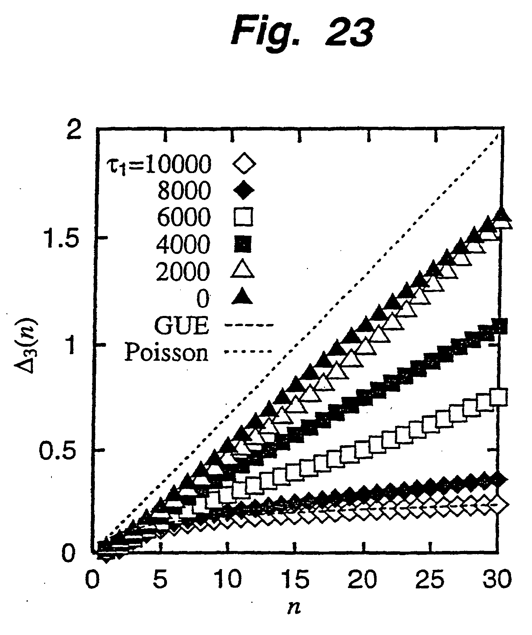

Since the stellar fractal structure analyzed here is one obtained by growth experiment of n=10000, this quantum system includes n+1=10001 eigenstates. Among them, based on energy eigenvalues concerning 1501 states from the 501-th to 2001-th eigenstates from the ground state, quantum level statistics values shown below were calculated. Figs. 22 and 23 show quantum level statistics in a stellar fractal structure of $(\alpha_1, \alpha_2)=(0, 2)$. Fig. 22 shows P(s) whereas Fig. 23 shows $\Delta_3$ statistics values. In case of $\tau_1$=10000, the structure is identical to the simple fractal of $\alpha$=0, and the fractal dimension is near 3($D_f$ - 2.91). Therefore, the system behaves as a quantum chaotic system. In this case, the quantum level statistics is that of GUE distribution. On the other hand, in case of $\tau_1$=0, the structure is identical to the simple fractal of $\alpha$=2, and the fractal dimension is near 2($D_f$ - 2.16). Therefore, the system behaves as an integrable system. Then, as $\tau_1$ increases from 0 to 10000, the quantum level statistics changes from Poisson distribution to GOE distribution. Therefore, a wide variety of quantum systems from a quantum chaotic system to an integrable system can be realized by adjusting $\tau_1$ at predetermined values.

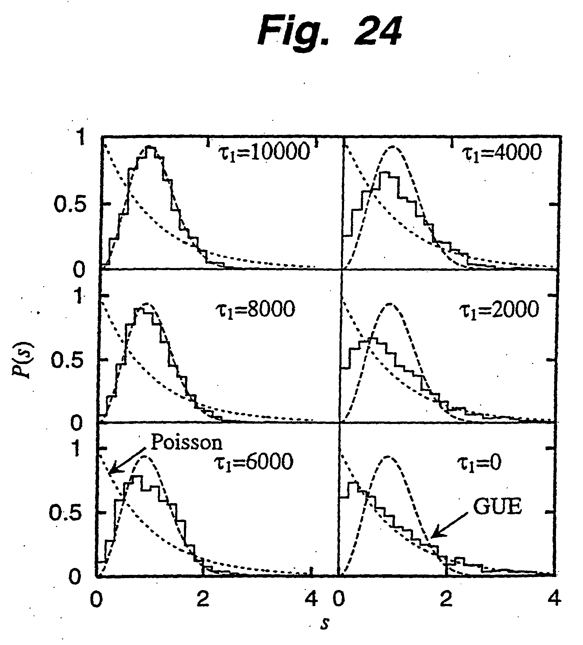

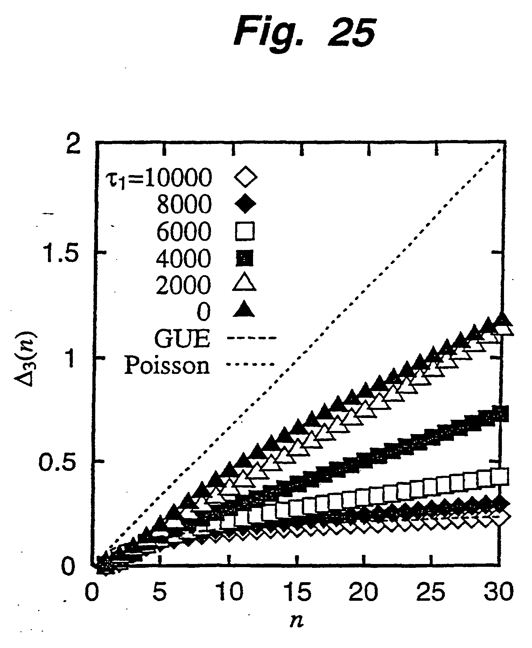

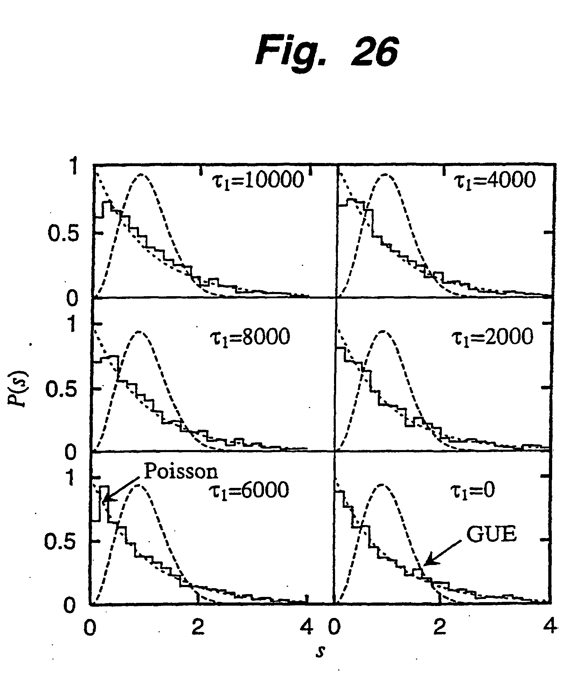

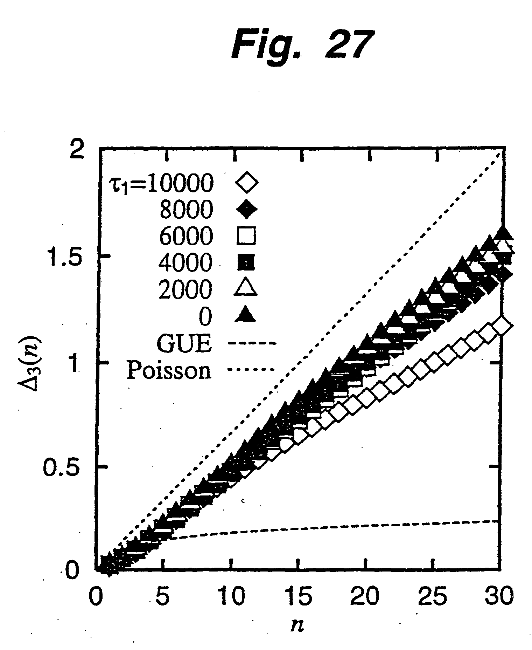

The foregoing example was a stellar fractal structure in which both $\alpha$=0 and $\alpha$=2 exist together. On the other hand, since the fractal dimension of the simple fractal structure of $\alpha$=1 is approximately ($D_f \sim 2.45$), it is even possible to connect the quantum chaotic system of $\alpha=0$ and the integrable system of $\alpha=2$. Figs. 24 and 25 show quantum level statistics in a stellar fractal structure of $(\alpha_1, \alpha_2)=(0, 1)$. Figs. 26 and 27 show quantum level statistics in a stellar fractal structure of $(\alpha_1, \alpha_2)=(1, 2)$. Among these figures, Figs. 24 and 26 show P(s) whereas Figs. 25 and 27 show $\Delta_3$ statistics values. $\tau_1$=10000 of Figs. 24 and 25 is a quantum chaotic system identical to $\tau_1$=10000 shown in Figs. 22 and 23. It is appreciated from Figs. 24 and 25 that, as $\tau_1$ decreases, the quantum level statistics value changes from that of GUE distribution to that of Poisson distribution. However, even under $\tau_1$=0 of Figs. 24 and 25, that is, in the simple fractal of $\alpha=1$, it does not become the complete Poisson distribution. Now turn the attention to Figs. 26 and 27. $\tau_1$=10000 of Figs. 26 and 27 is identical to $\tau_1$=0 of Figs. 24 and 25, and it is the quantum level statistics value in the simple fractal structure of $\alpha=1$. As $\tau_1$ decreases, the quantum level statistics value changes toward that of Poisson distribution, and in the range where $\tau_1$ is sufficiently small, it gradually approaches that of Poisson distribution. Of course, $\tau_1$=0 in Figs. 26 and 27 is the quantum level statistics value in the simple fractal of $\alpha=2$, and it is identical to $\tau_1$=0 of Figs. 22 and 23.

Instead of the change from the quantum chaotic system described by GOE distribution to the integrable quantum system described by Poisson distribution, which was observed when no magnetic field exists, a change from a quantum chaotic system described by GUE distribution to an integrable quantum system described by Poisson distribution was observed under a random magnetic field. That is, it has been confirmed that a wide variety of quantum chaotic systems from a quantum chaotic system described by GOE distribution to a quantum chaotic system described by GUE distribution can be obtained by controlling the degree the random magnetic field.

Fifth Embodiment

In the fifth embodiment, fractal dimensions suitable for controlling a correlated electron system by stellar fractal structures will be explained.

(1) Formation of a stellar fractal structure

The same method as used for forming the stellar fractal structure according to the first embodiment is used here again for forming a stellar fractal structure according to the fifth embodiment. Numerical experiments of growth, however, were carried out for various combinations of $(\alpha_1, \alpha_2)$ satisfying $\alpha_1<\alpha_2$ while fixing $\tau_1$=5000 and $\tau_2$=10000 as the growth condition.

It is known that a fractal structure formed by a method of forming a simplex fractal structure by Dielectric Breakdown Model changes in fractal dimension $D_f$ when $\alpha$ is changed. Fig. 28 shows fractal dimensions obtained by simulations (Literature (10) introduced above). It is appreciated from Fig. 28 that $D_f$ decreases as $\alpha$ increases. $D_f>2.7$ is obtained in the range of $\alpha<0.5$, and $F_f<2.3$ is obtained in the range of $\alpha>1$.

(2) Correlated electron system in the stellar fractal structure

An electron system is defined on the stellar fractal structure defined in (1). Assume a lattice site shown below, which is the origin of $T_n$

$$r_p = (i_{1,p}, i_{2,p}, i_{3,p}) \in T_n \tag{77}$$

where p=1, 2, $\cdots$, n+1. Here is defined an operator $\hat{c}_p^{\dagger}$ that creates an electron with the spin $\sigma$ at a lattice site $r_p \in T_n$. Of course, the anticommutative relation shown below holds.

$$\left\{ \hat{c}_{p,\sigma}, \hat{c}_{q,\rho}^{\dagger} \right\} = \delta_{p,q} \delta_{\sigma,\rho} \tag{78}$$

The single-band Hubbard Hamiltonian $\hat{H}$ of this electron system is defined as shown below.

$$\hat{H} = t \sum_{i,j,\sigma} \lambda_{i,j} \hat{c}_{i,\sigma}^{\dagger} \hat{c}_{j,\sigma} + U \sum_j \hat{n}_{j,\uparrow} \hat{n}_{j,\downarrow} \tag{79}$$

Assuming that electrons are movable only among nearest-neighbor sites, the following is employed as $\lambda_{p,q}$.

$$\lambda_{p,q} = \begin{cases} 1 & \text{when} |r_p - r_q| = 1 \\ 0 & \text{otherwise} \end{cases} \qquad (80)$$

Additionally, the spin $\sigma$ electron density operator of the j-th site, $\hat{n}_{j,\sigma} = \hat{c}_{j,\sigma}^{\dagger} \hat{c}_{j,\sigma}$, and the sum, $\hat{n}_j = \Sigma_\sigma \hat{n}_{j,\sigma}$, are defined.

For the purpose of defining a temperature Green's function, here is introduced a grand canonical Hamiltonian $\hat{K} = H - \mu N$ where $N = \Sigma_j n_j$. In the half-filled remarked here, chemical potential is $\mu = U/2$. The half-filled grand canonical Hamiltonian can be expressed as

$$\hat{K} = t \sum_{i,j,\sigma} \lambda_{j,i} \hat{t}_{j,i,\sigma} + U/2 \sum_i (\hat{u}_i - 1) \qquad (81)$$

Operators $\hat{t}_{j,i,\sigma}$, $\hat{j}_{j,i,\sigma}$, $\hat{u}_i$ and $\hat{d}_{i,\sigma}$ are defined beforehand by

$$\hat{t}_{j,i,\sigma} = \hat{c}_{j,\sigma}^{\dagger} \hat{c}_{i,\sigma} + \hat{c}_{i,\sigma}^{\dagger} \hat{c}_{j,\sigma} \qquad (82)$$

$$\hat{j}_{j,i,\sigma} = \hat{c}_{j,\sigma}^{\dagger} \hat{c}_{i,\sigma} - \hat{c}_{i,\sigma}^{\dagger} \hat{c}_{j,\sigma} \qquad (83)$$

$$\hat{u}_i = \hat{c}_{i,\uparrow}^{\dagger} \hat{c}_{i,\uparrow} \hat{c}_{i,\downarrow}^{\dagger} \hat{c}_{i,\downarrow} + \hat{c}_{i,\uparrow} \hat{c}_{i,\uparrow}^{\dagger} \hat{c}_{i,\downarrow} \hat{c}_{i,\downarrow}^{\dagger} \qquad (84)$$

$$\hat{d}_{i,\sigma} = \hat{c}_{i,\sigma}^{\dagger} \hat{c}_{i,\sigma} - \hat{c}_{i,\sigma} \hat{c}_{i,\sigma}^{\dagger} \qquad (85)$$

If the temperature Green function is defined for operators $\hat{A}$ and $\hat{B}$ given, using $\tau$ as imaginary time, it is as follows.

$$\langle \hat{A}; \hat{B} \rangle = -\int_0^\beta d\tau \langle T_\tau \hat{A}(\tau) \hat{B} \rangle e^{i\omega_n \tau} \qquad (86)$$

The on-site Green function

$$G_{j,\sigma}(i\omega_n) = \langle \hat{c}_{j,\sigma}; \hat{c}_{j,\sigma}^{\dagger} \rangle \qquad (87)$$

is especially important because, when analytic continuation is conducted as $i\omega_n \to \omega + i\delta$ for small $\delta$,

$$D_j(\omega) = -\text{Im} \, G_j(\omega + i\delta) \qquad (88)$$

becomes the local density of states of the site j, and

$$D(\omega) = -\frac{1}{n+1} \sum_j D_j(\omega) \qquad (89)$$

becomes the density of states of the system. When densities of states are numerically calculated later, $\delta=0.0001$ will be used.

Imaginary time development of the system is obtained by the following Heisenberg equation.

$$\frac{d}{d\tau}\,\hat{A}(\tau) = [\hat{K},\hat{A}] \tag{90}$$

As the equation of motion of the on-site Green function, the following is obtained.

$$i\omega_n\left\langle\hat{c}_{j,\sigma};\hat{c}^{\dagger}_{j,\sigma}\right\rangle = 1 + t\sum_{p,j}\lambda_{p,j}\left\langle\hat{c}_{p,\sigma};\hat{c}^{\dagger}_{j,\sigma}\right\rangle + \frac{U}{2}\left\langle\hat{d}_{j,-\sigma}\hat{c}_{j,\sigma};\hat{c}^{\dagger}_{j,\sigma}\right\rangle \tag{91}$$

Then, the approximation shown below is introduced, following Gros ((35) C. Gros, Phys. Rev. B50, 7295(1994)). If the site p is the nearest-neighbor site of the site j, the resolution

$$\left\langle\hat{c}_{p,\sigma};\hat{c}^{\dagger}_{j,\sigma}\right\rangle \rightarrow t\left\langle\hat{c}_{p,\sigma};\hat{c}^{\dagger}_{p,\sigma}\right\rangle\left\langle\hat{c}_{j,\sigma};\hat{c}^{\dagger}_{j,\sigma}\right\rangle \tag{92}$$

is introduced as the approximation. This is said to be exact in case of infinite-dimensional Bethe lattices, but in this case, it is only within approximation. Under this approximation, the following equation is obtained.

$$(i\omega_n - t^2\Gamma_{j,\sigma})G_{j,\sigma} = 1 + \frac{U}{2}\left\langle\hat{d}_{j,-\sigma}\hat{c}_{j,\sigma};\hat{c}^{\dagger}_{j,\sigma}\right\rangle \tag{93}$$

where

$$\Gamma_{j,\sigma} = \sum_{p}\lambda_{p,j}G_{p,\sigma} \tag{94}$$

was introduced. To solve the equation obtained,

$$\left\langle\hat{d}_{j,-\sigma}\hat{c}_{j,\sigma};\hat{c}^{\dagger}_{j,\sigma}\right\rangle$$

has to be analyzed. In case of half-filled models, this equation of motion is as follows.

$$i\omega_n\left\langle\hat{d}_{j,-\sigma}\hat{c}_{j,\sigma};\hat{c}^{\dagger}_{j,\sigma}\right\rangle = \frac{U}{2}G_{j,\sigma} - 2t\sum_{p}\lambda_{p,j}\left\langle\hat{j}_{p,j,-\sigma}\hat{c}_{j,\sigma};\hat{c}^{\dagger}_{j,\sigma}\right\rangle$$

$$+ t\sum_{p}\lambda_{p,j}\left\langle\hat{d}_{j,-\sigma}\hat{c}_{p,\sigma};\hat{c}^{\dagger}_{j,\sigma}\right\rangle \tag{95}$$

Here again, with reference to the Gros theory, approximation is introduced. It is the following translation.

$$\left\langle \hat{j}_{p,j,-\sigma}\hat{c}_{j,\sigma};\hat{c}^{\dagger}_{j,\sigma}\right\rangle \rightarrow -tG_{p,-\sigma}\left\langle \hat{d}_{j,-\sigma}\hat{c}_{j,\sigma};\hat{c}^{\dagger}_{j,\sigma}\right\rangle \qquad (96)$$

$$\left\langle \hat{d}_{j,-\sigma}\hat{c}_{p,\sigma};\hat{c}^{\dagger}_{j,\sigma}\right\rangle \rightarrow tG_{p,\sigma}\left\langle \hat{d}_{j,-\sigma}\hat{c}_{j,\sigma};\hat{c}^{\dagger}_{j,\sigma}\right\rangle \qquad (97)$$

As a result of this translation, the following closed equation is obtained.

$$\left(i\omega_n - t^2\Gamma_{j,\sigma}\right)G_{j,\sigma} = 1 + \frac{(U/2)^2}{i\omega_n - t^2\Gamma_{j,\sigma} - 2t^2\Gamma_{j,-\sigma}}G_{j,\sigma} \qquad (98)$$

Here is assumed that there is no dependency on spin. That is, assuming

$$G_j = G_{j,\uparrow} = G_{j,\downarrow} \qquad (99)$$

the following calculation is carried out.

In the following calculation, for the purpose of analyzing spatial changes inside the stellar fractal structure in detail, spatial changes of the local density of states $D_j(\omega=0)$ on the Fermi energy are analyzed. Let r represent the distance from the growth origin (0, 0, 0). Then, the aggregation of growth points distant from the growth origin by r to r+dr is expressed as $U_s(r)$, and the original number thereof is expressed by $M_s(r)$. Then, $D_{ave}(r)$ is defined as shown below.

$$D_{ave}(r) = \frac{1}{M_s(r)}\sum_{j\in U_s(r)}D_j(0) \qquad (100)$$

This quantity is the average value of densities of states on the Fermi energy on a spherical surface at the distance r from the growth origin. In this calculation, dr=1 is used.

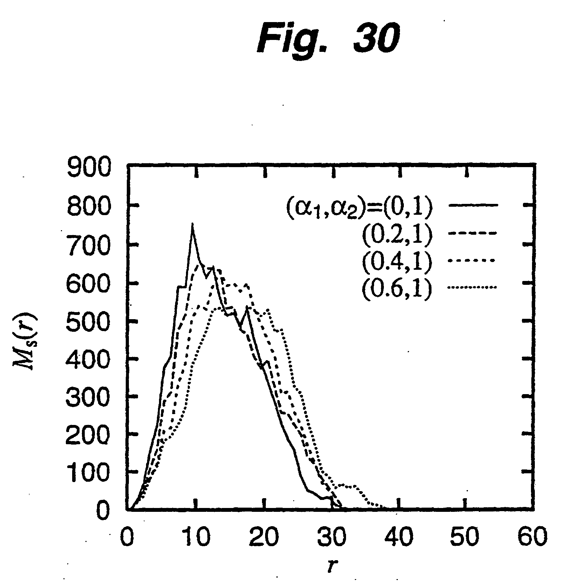

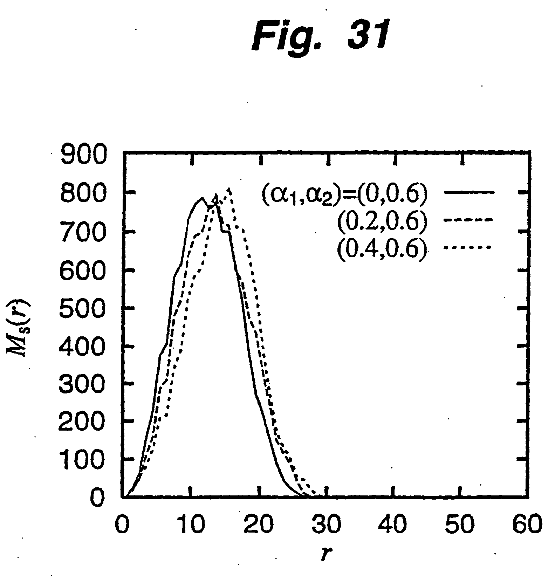

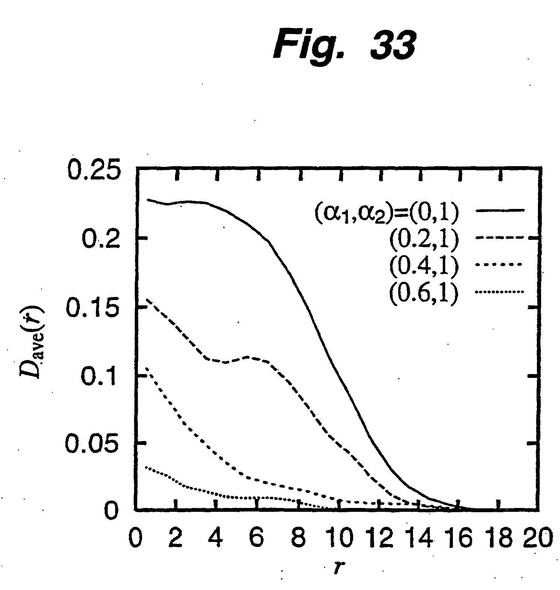

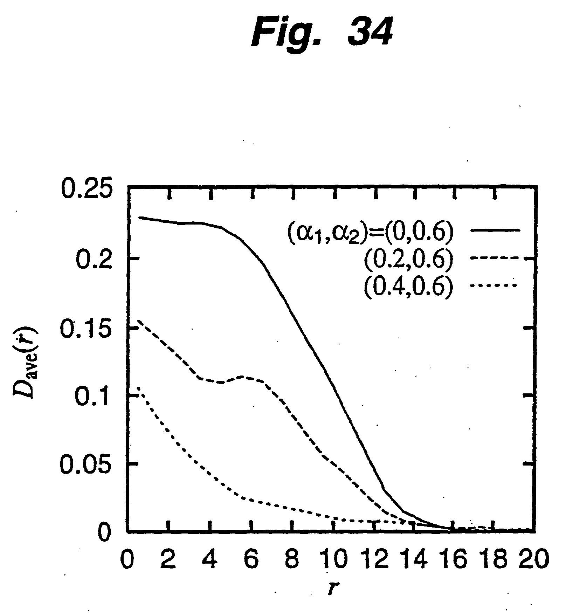

Fig. 29 shows $M_s(r)$ when $\alpha_2$ is fixed in $\alpha_2$=2 and $\alpha_1$ is changed to be $\alpha_1$=0, 0.2, 0.4, 0.6 and 1. Fig. 30 shows $M_s(r)$ when $\alpha_2$ is fixed in $\alpha_2$=1 and $\alpha_1$ is changed to be $\alpha_1$=0, 0.2, 0.4 and 0.6. Fig. 31 shows $M_s(r)$ when $\alpha_2$ is fixed in $\alpha_2$=0.6 and $\alpha_1$ is changed to be $\alpha_1$=0, 0.2 and 0.4. Fig. 32 shows $D_{ave}(r)$ when $\alpha_2$ is fixed in $\alpha_2$=2 and $\alpha_1$ is changed to be $\alpha_1$=0, 0.2, 0.4, 0.6 and 1. Fig. 33 shows $D_{ave}(r)$ when $\alpha_2$ is fixed in $\alpha_2$=1 and $\alpha_1$ is changed to be $\alpha_1$=0, 0.2, 0.4 and 0.6. Fig. 34 shows $D_{ave}(r)$ when $\alpha_2$ is fixed in $\alpha_2$=0.6 and $\alpha_1$ is changed to be $\alpha_1$=0, 0.2 and 0.4.

It is appreciated from Figs. 32, 33 and 34 that, in the range with small r, i.e. in the somatic fractal region, $D_{ave}(r)$ takes finite values, and the structure behaves like a metal. As r increases, $D_{ave}(r)$ decreases and gradually approaches zero. That is, Mott transition to an insulator occurs. To obtain sufficient changes in density of states, approximately $\alpha_1$<0.4 inside and approximately $\alpha_2$>1 outside are required, and approximately $D_f$>2.7 inside and approximately $D_f$<2.3 outside are required as fractal dimensions.

Sixth Embodiment

In the sixth embodiment, fractal dimensions suitable for controlling magnetization curves by stellar fractal structures will be explained.

(1) Formation of a stellar fractal structure

The same method as used for forming the stellar fractal structure according to the first embodiment is used here again for forming a stellar fractal structure according to the sixth embodiment. Numerical experiments of growth, however, were carried out for various combinations of $(\alpha_1, \alpha_2)$ satisfying $\alpha_1 < \alpha_2$ while fixing $\tau_1 = 5000$ and $\tau_2 = 10000$ as the growth condition.

(2) Ferromagnetic transition in the stellar fractal structure

A spin system describing a ferromagnetic structure is defined on the stellar fractal structure defined in (1). Assume the lattice site

$$r_p = (i_{1,p}, i_{2,p}, i_{3,p}) \in T_n \qquad (101)$$

that is the origin of $T_n$. In this Equation, p=1, 2, $\cdots$, n. By placing a spin on a lattice site $r_p \in T_n$, here is taken a spin system that can be described by the following Hamiltonian.

$$H = -\sum_{p,q} J_{p,q} S_p \cdot S_q \qquad (102)$$

$S_p$ is the spin at the p site. The following is a natural model of spin-to-spin interaction $J_{p,q}$.

$$J_{p,q} = \begin{cases} 1 & when |r_p - r_q| = 1 \\ 0 & otherwise \end{cases} \qquad (103)$$

That is, spin-to-spin interaction exists only between nearest-neighbor sites. For the purpose of calculating spontaneous magnetization M at a finite temperature T, statistical mechanics of an equilibrium system is introduced. A partition function Z is defined as follows.

$$Z = \sum_{\{S_p\}} e^{-H/T} \qquad (104)$$

where $\{S_p\}$ denotes the sum for all spin states. Spontaneous magnetization is defined as the statistical average of spins as follows.

$$M = \frac{1}{n+1} \sum_{p=1}^{n} \langle S_p \rangle \qquad (105)$$

where the expected value $\langle S_p \rangle$ is

$$\langle S_p \rangle = \frac{1}{Z} \sum_{\{S_p\}} S_p e^{-H/T} \qquad (106)$$

and n+1 is the total number of spins. In general, *M* is a vector quantity in a spin space, but its absolute value $M=|M|$ is calculated.
Here is made a review about an Ising model. In an Ising model, only two states of

$$S_p = 1 \text{ or } -1 \tag{107}$$

can exist. Let the average field approximation be introduced into the Ising model. Spontaneous magnetization of the p-th site is written as $\mu_p$. In this system, since the molecule field varies with site, let it be written as $\bar{\mu}_p$. As an assumption of the average field approximation, here is employed a molecule field that can be written by spontaneous magnetization of the nearest-neighbor site as

$$\bar{\mu}_p = \sum_q J_{p,q} \mu_q \tag{108}$$

This assumption simplifies the foregoing Hamiltonian to

$$H_{MF} = -\sum_{p=0}^{n} \bar{\mu}_p \sigma_p, \tag{109}$$

When deriving a self-consistent equation ensuring spontaneous magnetization obtained by using a partition function by the simplified Hamiltonian becomes $\mu_p$,

$$\mu_p = \tanh(\beta \bar{\mu}_p) \tag{110}$$

is obtained, and by numerically solving this equation, the following spontaneous magnetization of the system is determined.

$$M_{I\sin g} = \frac{1}{n+1} \sum_{j=0}^{n} \mu_j \tag{111}$$

Fig. 35 shows spontaneous magnetization obtained when $\alpha_1$ is fixed in $\alpha_1=0$ and $\alpha_2$ is changed. $\alpha_2=0$ corresponds to spontaneous magnetization in a structure similar to a simple fractal of $\alpha=0$. As compared with spontaneous magnetization on its structure, it changes toward bent spontaneous magnetization peculiar to stellar fractal structures with the increase of $\alpha_2$. In this case, favorable spontaneous magnetization is obtained around $\alpha_2 \geq 0.6$.

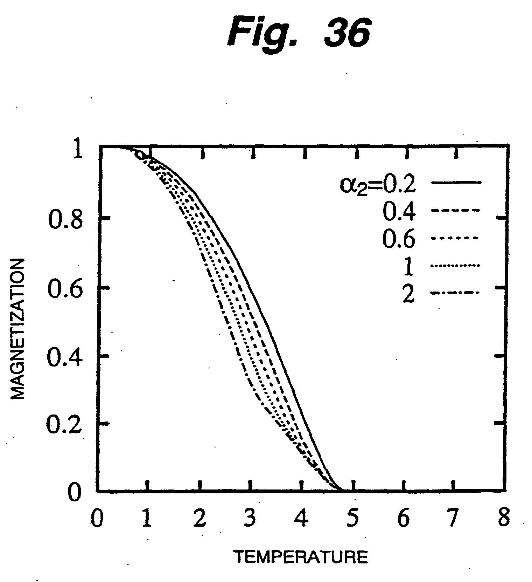

Fig. 36 shows spontaneous magnetization obtained when $\alpha_1$ is fixed in $\alpha_1=0.2$ and $\alpha_2$ is changed. $\alpha_2=0.2$ corresponds to spontaneous magnetization in a structure similar to a simple fractal of $\alpha=0.2$. As compared with spontaneous magnetization on the structure, it changes toward bent spontaneous magnetization peculiar to stellar fractal structures with the increase of $\alpha_2$. In this case, favorable spontaneous magnetization is obtained around $\alpha_2 \geq 1$.

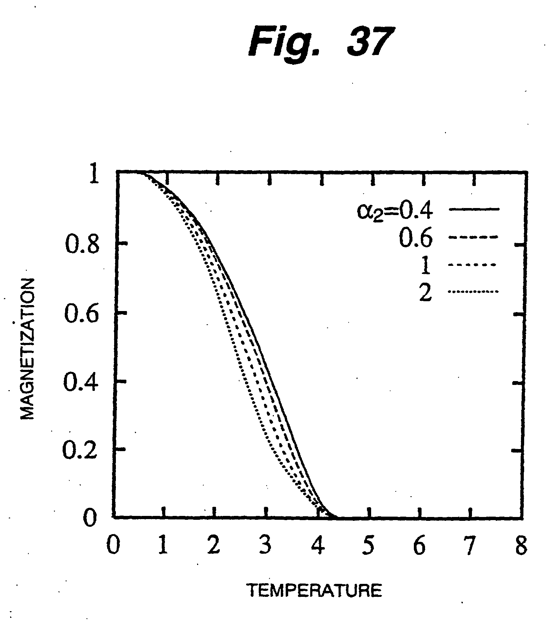

Fig. 37 shows spontaneous magnetization obtained when $\alpha_1$ is fixed in $\alpha_1=0.4$ and $\alpha_2$ is changed. $\alpha_2=0.4$ corresponds to spontaneous magnetization in a structure similar to a simple fractal of $\alpha=0.4$. As compared with spontaneous magnetization on the structure, it changes toward bent spontaneous magnetization peculiar to stellar fractal structures with the increase of $\alpha_2$. In this case, favorable spontaneous magnetization is obtained around $\alpha_2 \geq 1$.

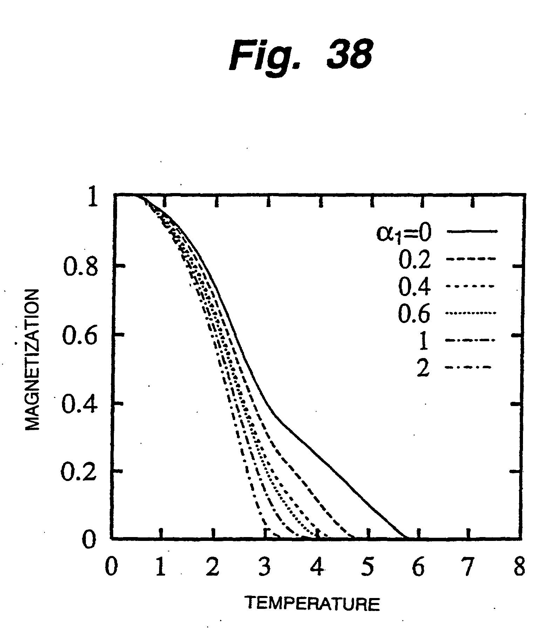

Fig. 38 shows spontaneous magnetization obtained when $\alpha_2$ is fixed in $\alpha_2=0.4$ and $\alpha_1$ is changed. $\alpha_1=2$ corresponds to spontaneous magnetization in a structure similar to a simple fractal of $\alpha=2$. As compared with spontaneous magnetization on the structure, it changes toward bent spontaneous magnetization peculiar to stellar fractal structures with the decrease of $\alpha_2$. In this case, favorable spontaneous magnetization is obtained around $\alpha_1 \geq 0.4$.

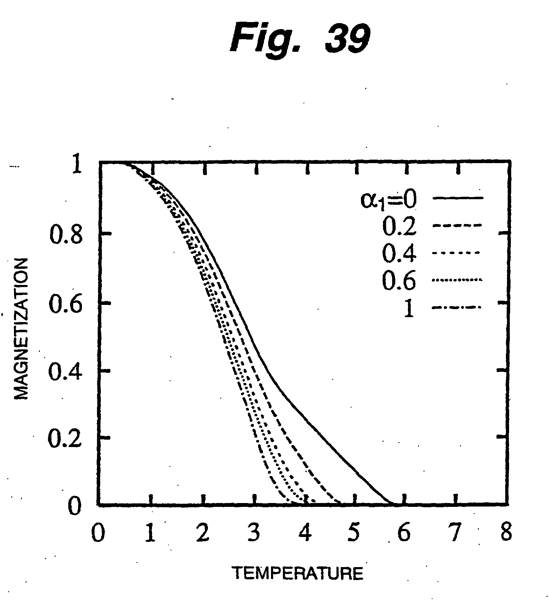

Fig. 39 shows spontaneous magnetization obtained when $\alpha_2$ is fixed in $\alpha_2=1$ and $\alpha_1$ is changed. $\alpha_1=1$ corresponds to spontaneous magnetization in a structure similar to a simple fractal of $\alpha=1$. As compared with spontaneous magnetization on the structure, it changes toward bent spontaneous magnetization peculiar to stellar fractal structures with the decrease of $\alpha_2$. In this case, favorable spontaneous magnetization is obtained around $\alpha_1 \geq 0.2$.

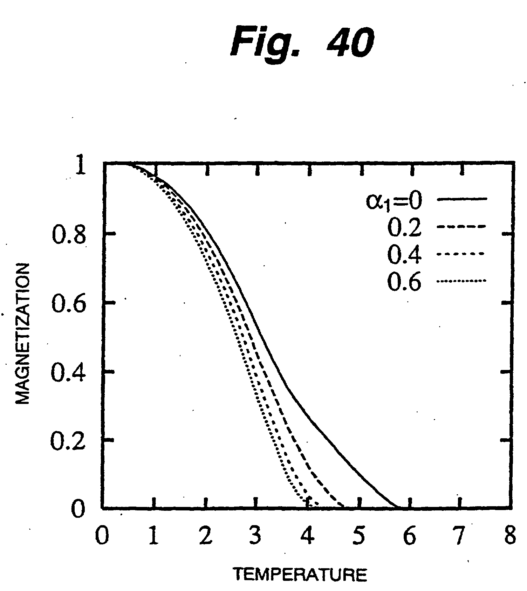

Fig. 40 shows spontaneous magnetization obtained when $\alpha_2$ is fixed in $\alpha_2=0.6$ and $\alpha_1$ is changed. $\alpha_1=0.6$ corresponds to spontaneous magnetization in a structure similar to a simple fractal of $\alpha=0.6$. As compared with spontaneous magnetization on the structure, it changes toward bent spontaneous magnetization peculiar to stellar fractal structures with the decrease of $\alpha_2$. In this case, favorable spontaneous magnetization is obtained around $\alpha_1 \geq 0.2$.

From those results, when the fractal dimension of the inner somatic region of a stellar fractal structure satisfies the condition of $D_f > 2.7$ approximately, or the fractal dimension of the outer dendritic region satisfies the condition of $D_f < 2.3$ approximately, magnetization curve in the stellar fractal structure exhibits characteristic behaviors, and favorable control is possible.

Seventh Embodiment

(1) Formation of a stellar fractal structure

The same method as used for forming the stellar fractal structure according to the first embodiment is used here again for forming a stellar fractal structure according to the seventh embodiment. Numerical experiments of growth, however, were carried out by using various combinations of $(\alpha_1, \alpha_2)$ satisfying $\alpha_1 < \alpha_2$, especially 0, 0.2, 0.4, 0.6, 1 and 2 as $\alpha_1$ and $\alpha_2$ while fixing $\tau_1 = 5000$ and $\tau_2 = 10000$ as the growth condition.

(2) Electron system on the stellar fractal structure

By substantially the same method as that shown by Equations (44) through (59) of the third embodiment, a quantum system of a single particle is defined on the stellar fractal structure defined in (1).

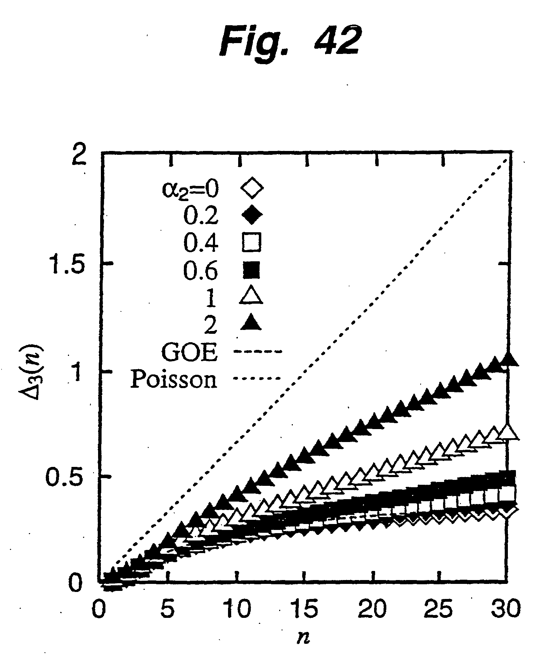

Since the stellar fractal structure analyzed here is one obtained by growth experiment of n=10000, this quantum system includes n+1=10001 eigenstates. Among them, based on energy eigenvalues concerning 1501 states from the 501-th to 2001-th eigenstates from the ground state, quantum level statistics values shown below were calculated. Figs. 41 and 42 show quantum level statistics in stellar fractal structures in which $(\alpha_1, \alpha_2)=(0, x)$ and x=0, 0.2, 0.4, 0.6, 1 and 2. Fig. 41 shows P(s) whereas Fig. 42 shows $\Delta_3$ statistics values. In case of $\alpha_2=0$, the structure is identical to a simple fractal of $\alpha=0$, and the fractal dimension is near $3(D_f \sim 2.91)$. Therefore, the system behaves as a quantum chaotic system. In this case, the quantum level statistics is that of GOE distribution. As $\alpha_2$ increases, the quantum level statistics goes apart from that of GOE distribution and approaches Poisson distribution. However, even after it reaches $\alpha_2=2$, there remains a large difference from Poisson distribution.

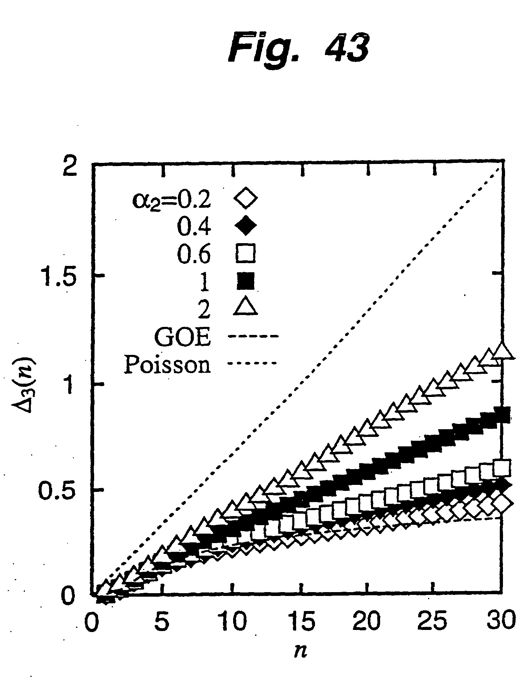

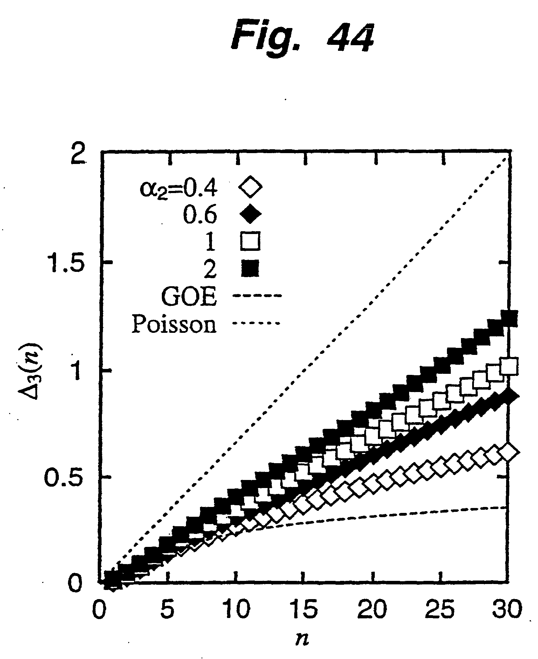

Fig. 43 shows $\Delta_3$ statistics values in stellar fractal structures in which $(\alpha_1, \alpha_2)=(0.2, x)$ and x=0.2, 0.4, 0.6, 1 and 2. In case of $\alpha_2=0.2$, the structure is identical to a simple fractal of $\alpha=0.2$, and it behaves as a quantum chaotic system. As $\alpha_2$ increases, the quantum level statistics goes apart from that of GOE distribution and approaches Poisson distribution. Fig. 44 shows $\Delta_3$ statistics values in stellar fractal structures in which $(\alpha_1, \alpha_2)=(0.4, x)$ and x=0.4, 0.6, 1 and 2. In case of $\alpha_2=0.4$, the structure is identical to a simple fractal of $\alpha=0.4$, and it is far from that of GOE distribution as much as it cannot be regarded as a quantum chaotic system. Here again, as $\alpha_2$ increases, the quantum level statistics goes apart from that of GOE distribution and approaches Poisson distribution.

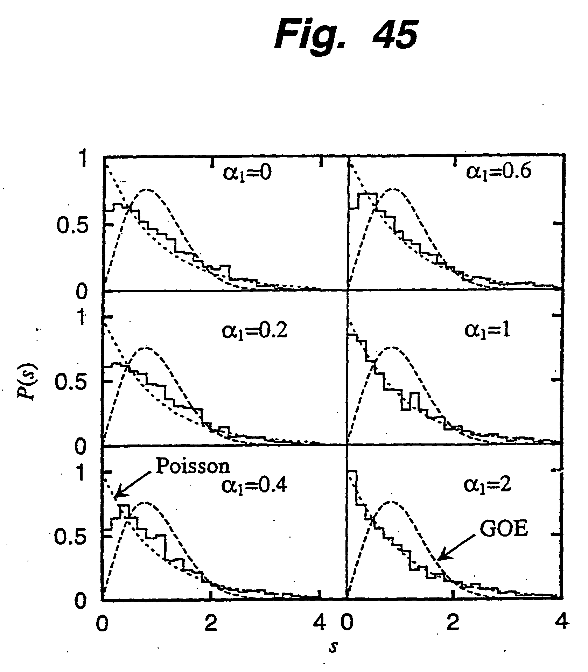

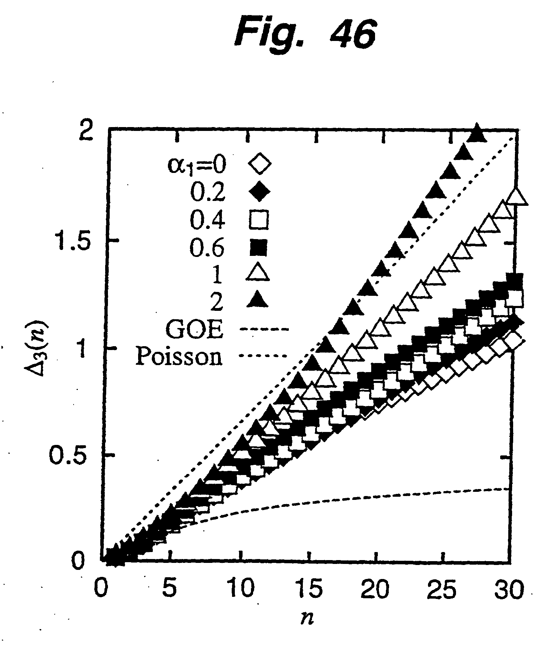

Figs. 45 and 46 show quantum level statistics in stellar fractal structures in which $(\alpha_1, \alpha_2)=(x, 2)$ and x=0, 0.2, 0.4, 0.6, 1 and 2. Fig. 45 shows P(s) whereas Fig. 46 shows $\Delta_3$ statistics values. In case of $\alpha_1=0$, similarly to the case of $\alpha_2=2$ of Figs. 41 and 42, the structure is identical to a simple fractal structure of $\alpha=2$, and the fractal dimension is near $2(D_f \sim 2.16)$. Therefore, the system behaves as an integrable system. As $\alpha_1$ decreases, the quantum level statistics goes apart from that of Poisson distribution and approaches that of GOE distribution.

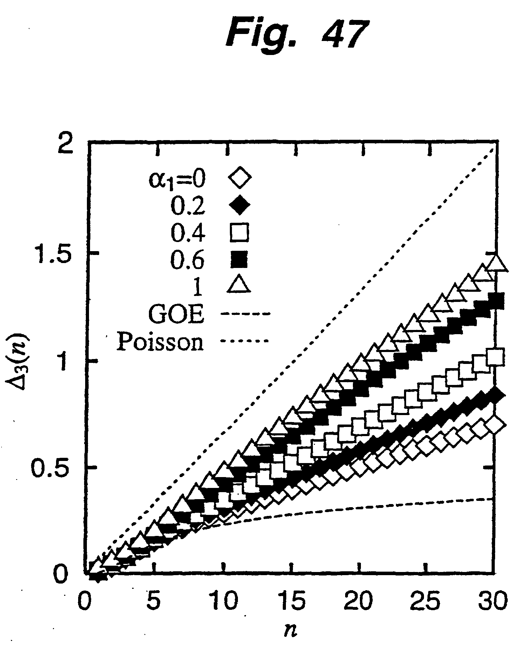

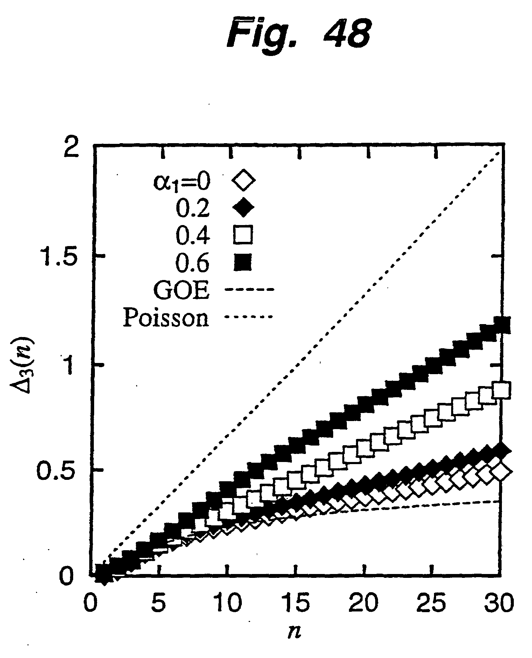

Fig. 47 shows $\Delta_3$ statistics values in stellar fractal structures in which $(\alpha_1, \alpha_2)=(x, 1)$ and x=0, 0.2, 0.4, 0.6 and 1. Fig. 48 shows $\Delta_3$ statistics values in stellar fractal structures in which $(\alpha_1, \alpha_2)=(x, 0.6)$ and x=0, 0.2, 0.4 and 0.6. As $\alpha_1$ decreases, the quantum level statistics goes apart from that of Poisson distribution and approaches that of GOE distribution.

For the purpose of quantitatively evaluating the above-mentioned controllability, Berry-Robnik parameter $\rho$ is used ((14) M.V. Berry and M. Robnik, J. Phys. A (Math. Gen.) 17, 2413(1984)). First, when $\bar{\rho}=1-\rho$,

$$P_2(s,\rho) = \rho^2 e^{-\rho s}\, erf\left(\frac{\sqrt{\pi}\,\bar{\rho}s}{2}\right) + \left(2\rho\bar{\rho} + \frac{\pi\bar{\rho}^3 s}{2}\right)e^{-\rho s - \pi\bar{\rho}^2 s^2/4} \qquad (112)$$

is introduced, where

$$erf(x) = \frac{2}{\sqrt{\pi}} \int_x^\infty d\tau e^{-\tau^2} \qquad\qquad (113)$$

was used. This function $P_2(s, \rho)$ coincides with P(s) of Poisson distribution under $\rho=1$, and coincides with P(s) of GOE distribution under $\rho=0$. That is, by changing $\rho$ from 0 to 1, quantum level statistics from those of quantum chaotic systems to those of integrable systems can be interpolated. The Berry-Robnik parameter is the value of $\rho$ obtained by optimum approximation of P(s) obtained by numerical calculation with $P_2(s, \rho)$ shown above. Within the range of semi classical approximation, $\rho$ is the volume ratio of regular regions (integrable systems and regions capable of perturbing development therefrom) in a phase space.

Fig. 49 shows the Berry-Robnik parameter $\rho$ in stellar fractal structures. $(\alpha_1, \alpha_2)=(x, 2)$ is the Berry-Robnik parameter in the case where $\alpha_1$ is placed and changed on the abscissa while fixing $\alpha_2=2$, and $(\alpha_1, \alpha_2)=(0, x)$ is the Berry-Robnik parameter in the case where $\alpha_2$ is placed and changed on the abscissa while fixing $\alpha_1=0$. As apparent from Fig. 49, it has been confirmed that a wide variety of quantum systems from quantum chaotic systems to integrable systems can be realized by adjusting $(\alpha_1, \alpha_2)$ to predetermined values.

Eighth Embodiment

(1) Formation of a stellar fractal structure

The same method as used for forming the stellar fractal structure according to the first embodiment is used here again for forming a stellar fractal structure according to the eighth embodiment. Numerical experiments of growth, however, were carried out by using $\tau_1=5000$, $\tau_2=10000$, $\alpha_1=0$ and $\alpha_2=2$. Fig. 50 shows a stellar fractal structure obtained thereby. In the stellar fractal structure shown in Fig. 50, the dendritic portion (j>5000) is shown in Fig. 51. The central portion of the stellar fractal structure shown in Fig. 50 is called a somatic region. The stellar fractal structure obtained in this manner is used for the following analysis.

Electron states in the stellar fractal structure are remarked. It is well known that conduction bandwidth $T_{eff}$ of a crystal is proportional the number of nearest-neighbor atoms in each site. In case of a tetragonal lattice, the number of nearest-neighbor atoms is double the dimension. Therefore, it is expected that the bandwidth of the conduction band is proportional to the dimension. In fractal structures, $T_{eff}$ is considered to be approximately proportional to the fractal dimension $D_f$.

That is, it can be written as follows.

$$T_{eff} = aD_f \qquad\qquad (114)$$

where $\underline{a}$ is the proportionality constant.

Fig. 52 schematically shows a stellar fractal structure. In this stellar fractal structure, a plurality of regions different in fractal dimension are in contact. In this case, in the somatic region (central portion) of the stellar fractal structure, the fractal dimension is larger, and a wide band electron state is formed. In the dendritic region, the fractal dimension is smaller, and a narrow band electron state is formed. I can be considered from the foregoing discussion that a potential barrier against electrons is formed at the junction interface even in the heterojunction of the stellar fractal structure similarly to a heterojunction of a compound semiconductor.

Here is reviewed a case where a stellar fractal structure of this kind is grown from a plurality of origins to form a plurality of somatic regions (Fig. 53). In case the growth is continued until a dendritic region grown from a certain origin merges another dendritic region grown from another origin, double heterojunctions made of somatic/dendritic/somatic regions can be formed as shown in Fig. 54. Fig. 5 shows conduction bands of the double heterojunctions.

In order to form a magnetic stellar fractal structure, it is preferably grown by using a diffusion process using molecules equal in spin state as molecule materials of the components ((15) M.M. Matsushita, et al. J. Am. Chem. Soc. 119, 4369(1997); (16) W. Fujita and K. Awaga, J. Am. Chem. Soc. 119, 4563(1997); (17) H. Sakurai, et al. J. Am. Chem. Soc. 121, 9723(2000); and (18) J. Nakazaki, et al. Chem. Phys. Lett. 319, 385(2000)). However, as shown in Fig. 56, for example, a stellar fractal structure can be formed even by placing these molecules 1 on a substrate 2 by using a probe 3 of a scanning type tunneling microscope (STM).

(2) Ferromagnetic transition in the stellar fractal structure

A spin system describing a ferromagnetic structure is defined on the stellar fractal structure defined in (1). Assume the lattice site

$$r_p = (i_{1,p}, i_{2,p}, i_{3,p}) \in T_n \tag{115}$$

that is the origin of $T_n$. In this Equation, p=1, 2, ···, n+1. By placing a spin on a lattice site $r_p \in T_n$, here is taken a spin system that can be described by the following Hamiltonian.

$$H = -\sum_{p,q} J_{p,q} S_p \cdot S_q \tag{116}$$

$S_p$ is the spin at the p site. The following is a natural model of spin-to-spin interaction $J_{p,q}$.

$$J_{p,q} = \begin{cases} 1 & when \left| r_p - r_q \right| = 1 \\ 0 & otherwise \end{cases} \tag{117}$$

That is, spin-to-spin interaction exists only between nearest-neighbor sites. For the purpose of calculating spontaneous magnetization M at a finite temperature T, statistical mechanics of an equilibrium system is introduced. A partition function Z is defined as follows.

$$Z = \sum_{\{S_p\}} e^{-H/T} \tag{118}$$

where $\{S_p\}$ denotes the sum for all spin states. Spontaneous magnetization is defined as the statistical average of spins. As the spatial average of local spontaneous magnetization $M_j = \langle S_j \rangle$, spontaneous magnetization of the entire system is defined as follows.

$$M = \frac{1}{n+1} \sum_{p=1}^{n+1} M_p \tag{119}$$

where the expected value <$S_p$> is

$$\langle S_p \rangle = \frac{1}{Z} \sum_{\{S_p\}} S_p e^{-H/T} \tag{120}$$

and n+1 is the total number of spins. In general, *M* is a vector quantity in a spin space, but its absolute value *M*=|*M*| is calculated.

This spin system is analyzed by Monte Carlo simulation. As the degree of spin freedom, a three-dimensional vector having values at apexes of an octahedron is employed. That is, as values of spins, Sp=(1, 0, 0), (-1, 0, 0), (0, 1, 0), (0, -1, 0), (0, 0, 1) and (0, 0, -1) are available. By using the Metropolis method that is one of Monte Carlo methods, spontaneous magnetization is computed. The number of Monte Carlo steps was 150000.

In the following analysis, it will be shown that paramagnetic regions and ferromagnetic regions are spatially formed to make a heterojunction.

For the purpose of analyzing spatial changes inside the stellar fractal structure in detail, spatial changes of spontaneous magnetization $M_j$ are analyzed. Let r represent the distance from the growth origin (0, 0, 0). Then, the aggregation of growth points distant from the growth origin by r to r+dr is expressed by w(r), and the original number thereof is expressed by $\Omega(r)$. Fig 57 shows $\Omega(r)$ for various values of $\alpha_1$.

Then, $D_{ave}(r)$ is defined as shown below.

$$M_{ave}(r) = \frac{1}{\Omega(r)} \sum_{j \in w(r)} M_j \qquad\qquad (121)$$

This quantity is the average value of spontaneous magnetization on a spherical surface at the distance r from the growth origin. In this calculation, dr=1 is used.

Fig. 58A shows $M_{ave}(r)$ in the case where $\alpha_1$=0 and $\alpha_2$=2. Fig. 58B shows $M_{ave}(r)$ in the case where $\alpha_1$=0.2 and $\alpha_2$=2. Fig. 58C shows $M_{ave}(r)$ in the case where $\alpha_1$=0.4 and $\alpha_2$=2. Fig. 58D shows $M_{ave}(r)$ in the case where $\alpha_1$=0.6 and $\alpha_2$=2.

It is appreciated from Figs. 58A through 58D that spontaneous magnetization exists over the entire region at low temperatures T<0.3 and that a long-distance order has been formed. As the temperature rises, $M_{ave}(r)$ takes finite values and the structure behaves as ferromagnetism in the region with small r, i.e. in the somatic region. However, as r increases, $M_{ave}(r)$ decreases gradually toward zero. Spontaneous magnetization disappears in the dendritic region, and the region exhibits paramagnetism. That is, it has been confirmed that phase separation of ferromagnetism and paramagnetism has occurred via the heterojunction between the somatic region and the dendritic region.

Here is made a review on the case where double heterojunctions are formed as shown in Fig. 54 by growth of the stellar fractal structure from a plurality of origins. In the temperature range having realizing the phase separation, there is no spin correlation among somatic regions. Once the temperature of the double heterojunctions is lowered, an order is born in the dendritic region, long-distance correlation is generated in the entirety of the somatic/dendritic/somatic regions. Therefore, it has been confirmed that spin correlation between somatic regions can be switched ON and OFF by changing the temperature that is an external parameter.

Bonding of a plurality of regions separated via double heterojunctions can be switched by changing an external parameter (for example, temperature) to derive the functionality and realize a functional device.

The foregoing first to eighth embodiments have been directed to stepwise heterojunctions. In the next ninth and tenth embodiments, however, models with inclined heterojunctions will be explained.

Ninth Embodiment

While the method for forming the stellar fractal structure according to the invention changes the $\alpha$ parameter step by step for individual growth steps n to make stepwise heterojunctions, the method for forming the stellar fractal structure according to the ninth embodiment changes the $\alpha$ parameter continuously in a stepless manner in accordance with the growth steps n to make inclined heterojunctions. More specifically, growth is progressed by using $\alpha(n)=\alpha_1$ in the range of $1 \leq n \leq \tau_1$ and using

$$\alpha(n) = \alpha_1 + \frac{\alpha_2 - \alpha_1}{\tau_2 - \tau_1} (n - \tau_1) \qquad\qquad (122)$$

in the range of $\tau_1 + 1 \leq n \leq \tau_2$. In the range of $\tau_2 + 1 \leq n \leq \tau_3$, $\alpha(n)=\alpha_2$ is used. Then, the following values are employed.

$$\tau_1 = 5000 - \tau_g/2 \qquad\qquad (123)$$

$$\tau_2 = 5000 + \tau_g/2 \qquad\qquad (124)$$

That is, the value of $\alpha$ continuously changes for the time $\tau_g$, and it is controlled to change from $\alpha_1$ to $\alpha_2$. In the other respects, the method according to the ninth embodiment is identical to the method according to the first embodiment.

(2) Correlated electron system in the stellar fractal structure

Mott transition of the stellar fractal structure obtained by (1) was analyzed by the same technique as that used in the first embodiment. Its results will be explained below.

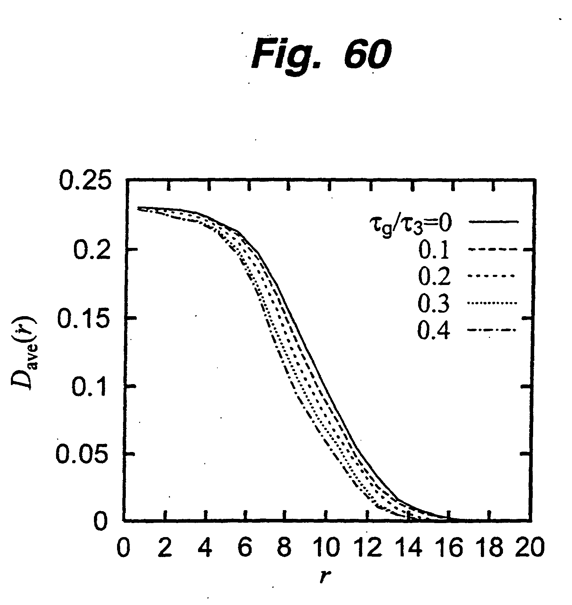

Fig. 59 shows $D_{ave}(r)$ under the condition of $(\alpha_1, \alpha_2)=(0, 2)$ and $\tau_g=0$ for various values of U. It is appreciated from Fig. 59 that the entire system behaves as a metal phase when U is very small and that the entire system behaves as a Mott insulative phase when U is very large. A review is made on the case where U takes an intermediate value such as U=7. In the region with small r, i.e. in the somatic region, $D_{ave}(r)$ takes finite values, and the system behaves like a metal. As r increases, $D_{ave}(r)$ decreases and gradually approaches zero. That is, Mott transition to an insulator occurs. In other words, there appears a hybrid electron system, i.e. a heterotic electron phase, combining a metal phase and a Mott insulative phase via the junction of the stellar fractal structure. Fig. 60 shows $D_{ave}(r)$ under the condition of $(\alpha_1, \alpha_2)=(0, 2)$ and U=7 for various values of $\tau_g$, namely, $\tau_g=0$, 1000, 2000, 3000 and 4000. It is appreciated from Fig. 60 that $D_{ave}(r)$ does not vary so much with $\tau_g$, and it is demonstrated that junctions with stepless changes of fractal dimensions do not exert large influences.

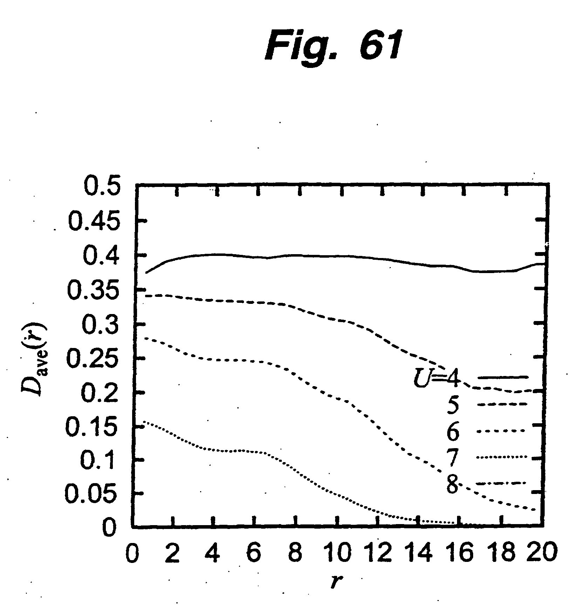

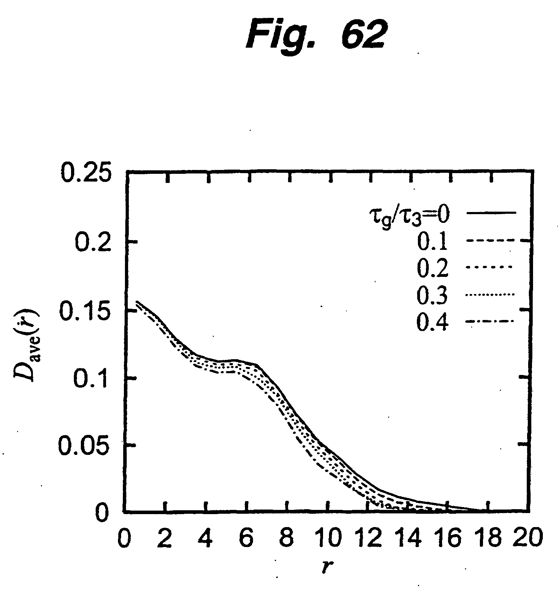

Fig. 61 shows $D_{ave}(r)$ under the condition of $(\alpha_1, \alpha_2)=(0.2, 2)$ and $\tau_g=0$ for various values of U. Fig. 62 shows $D_{ave}(r)$ under the condition of $(\alpha_1, \alpha_2)=(0.2, 2)$ and U=7 for various values of $\tau_g$, namely, $\tau_g=0$, 1000, 2000, 3000 and 4000.

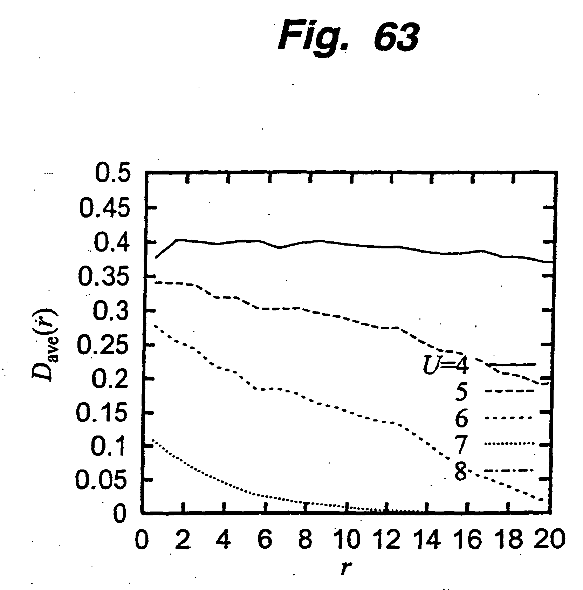

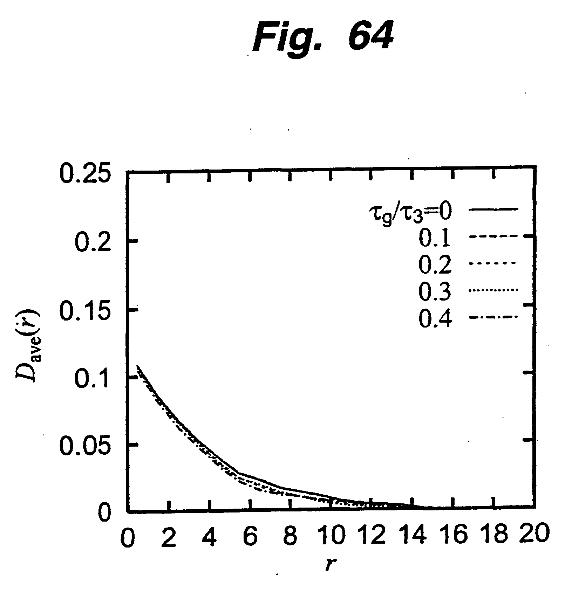

Fig. 63 shows $D_{ave}(r)$ under the condition of $(\alpha_1, \alpha_2)=(0.4, 2)$ and $\tau_g=0$ for various values of U. Fig. 64 shows $D_{ave}(r)$ under the condition of $(\alpha_1, \alpha_2)=(0.4, 2)$ and U=7 for various values of $\tau_g$, namely, $\tau_g=0$, 1000, 2000, 3000 and 4000.

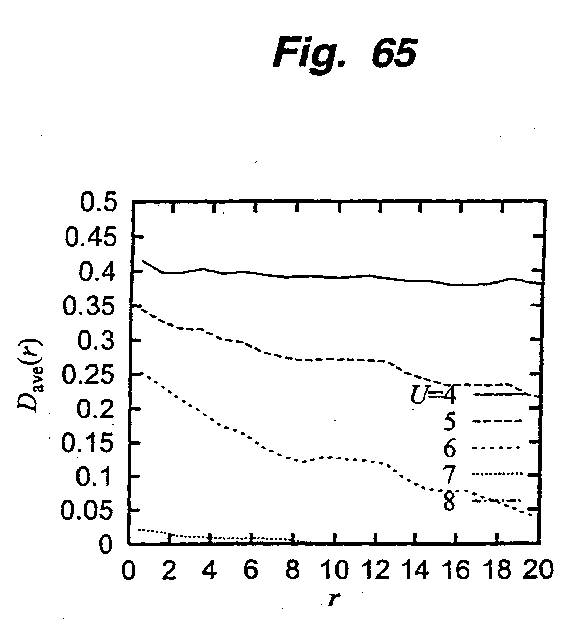

Fig. 65 shows $D_{ave}(r)$ under the condition of $(\alpha_1, \alpha_2)=(0.6, 2)$ and $\tau_g=0$ for various values of U. Fig. 64 shows $D_{ave}(r)$ under the condition of $(\alpha_1, \alpha_2)=(0.6, 2)$ and U=7 for various values of $\tau_g$, namely, $\tau_g=0$, 1000, 2000, 3000 and 4000.

Those results demonstrate that, under various $\alpha_1$, $D_{ave}(r)$ does not change so much with $\tau_g$, and stepless change of fractal dimensions gives only small influences to heterotic electron phase.

Tenth Embodiment

(1) Formation of a stellar fractal structure

The stellar fractal structure according to the tenth embodiment is formed in the same process as the method of fabricating the stellar fractal structure according to the ninth embodiment.

(2) Ferromagnetic transition in the stellar fractal structure

Ferromagnetic transition of the stellar fractal structure obtained in (1) was analyzed by the same technique as that used in the eighth embodiment. Its results will be explained below.

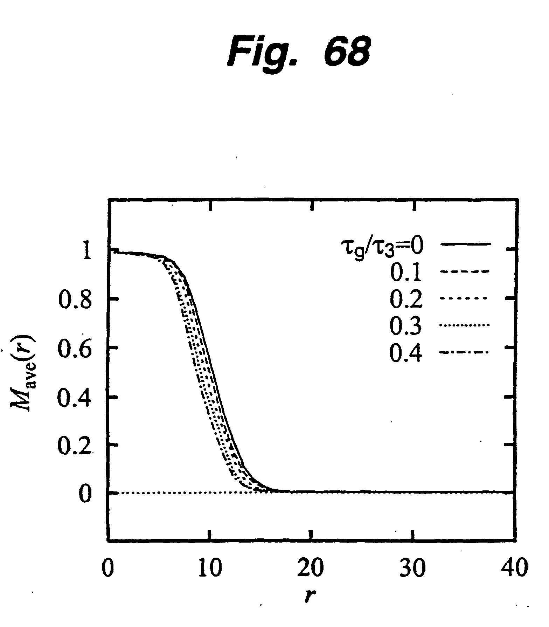

Fig. 67 shows $D_{ave}(r)$ under the condition of $(\alpha_1, \alpha_2)=(0, 2)$ and $\tau_g=0$ for various values of T. It is appreciated from Fig. 67 that spontaneous magnetization exists over the entire region at low temperatures T<0.3 and that a long-distance order has been formed. As the temperature T rises, $M_{ave}(r)$ takes finite values and the structure behaves as ferromagnetism in the region with small r, i.e. in the somatic region. However, as r increases, $M_{ave}(r)$ decreases gradually toward zero. In the dendritic region, spontaneous magnetization disappears, and the structure exhibits paramagnetism. That is, there appears a heterotic phase by a hybrid combination of ferromagnetism and paramagnetism via the heterojunction between the somatic region and the dendritic region. Fig. 68 shows $D_{ave}(r)$ under the condition of $(\alpha_1, \alpha_2)=(0, 2)$ and T=1 for various value of $\tau_g$, namely, $\tau_g=0$, 1000, 2000, 3000 and 4000. It is appreciated from Fig. 68 that $D_{ave}(r)$ does not change so much with $\tau_g$, and junctions with stepless changes of fractal dimensions give only small influences to heterotic electron phase.

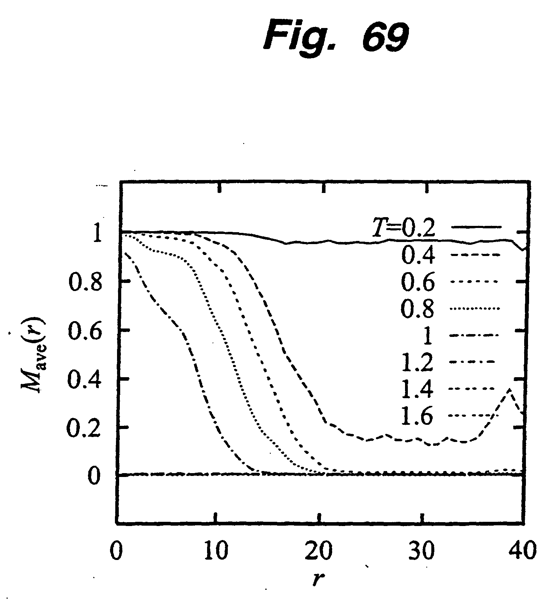

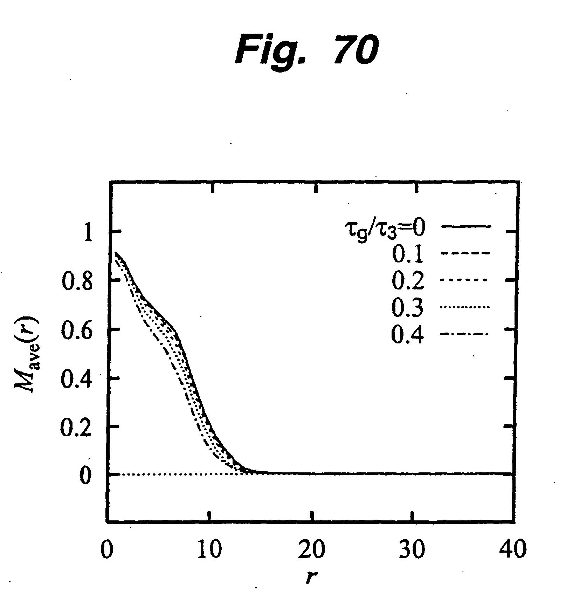

Fig. 69 shows $D_{ave}(r)$ under the condition of $(\alpha_1, \alpha_2)=(0.2, 2)$ and $\tau_g=0$ for various values of T. Fig. 70 shows $D_{ave}(r)$ under the condition of $(\alpha_1, \alpha_2)=(0.2, 2)$ and T=1 for various values of $\tau_g$, namely, $\tau_g=0$, 1000, 2000, 3000 and 4000.

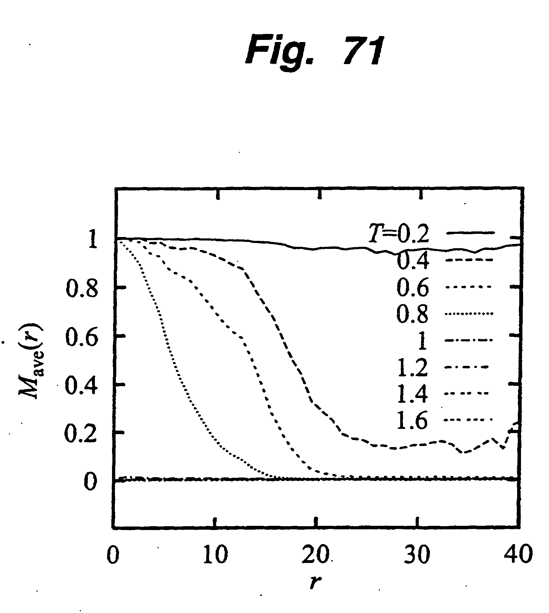

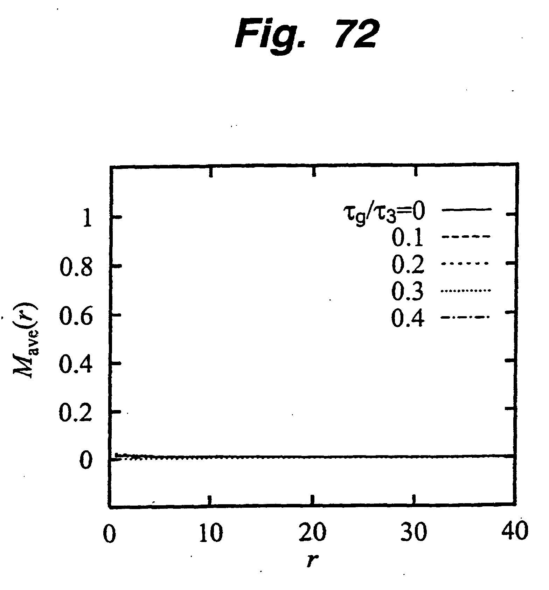

Fig. 71 shows $D_{ave}(r)$ under the condition of $(\alpha_1, \alpha_2)=(0.4, 2)$ and $\tau_g=0$ for various values of T. Fig. 72 shows $D_{ave}(r)$ under the condition of $(\alpha_1, \alpha_2)=(0.4, 2)$ and T=1 for various values of $\tau_g$, namely, $\tau_g=0$, 1000, 2000, 3000 and 4000.

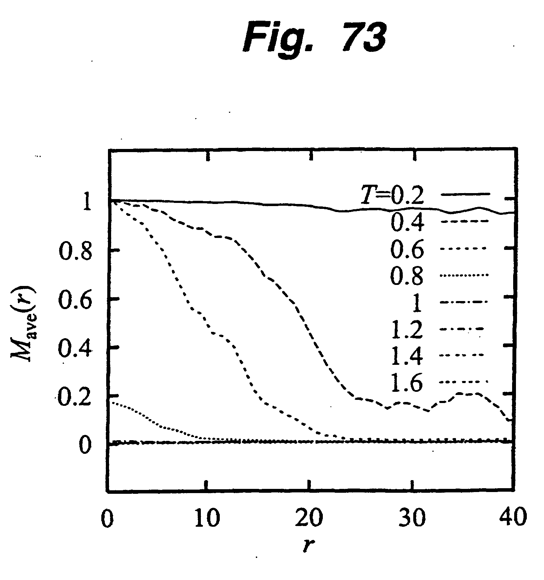

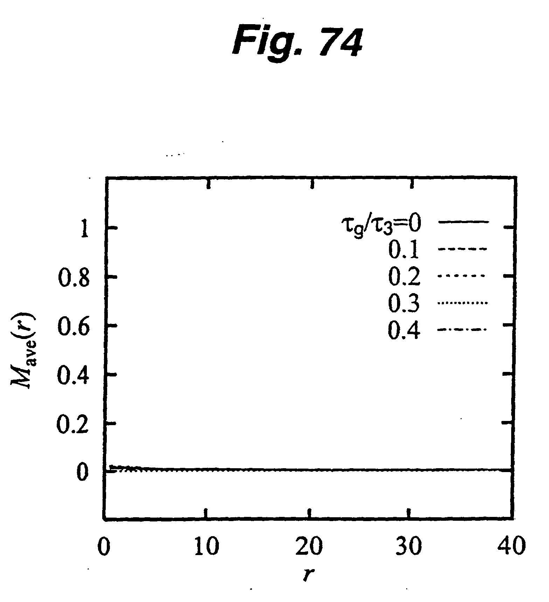

Fig. 73 shows $D_{ave}(r)$ under the condition of $(\alpha_1, \alpha_2)=(0.6, 2)$ and $\tau_g=0$ for various values of T. Fig. 74 shows $D_{ave}(r)$ under the condition of $(\alpha_1, \alpha_2)=(0.6, 2)$ and T=1 for various values of $\tau_g$, namely, $\tau_g=0$, 1000, 2000, 3000 and 4000.

Those results demonstrate that, under various $\alpha_1$, $D_{ave}(r)$ does not change so much with $\tau_g$, and stepless change of fractal dimensions gives only small influences to heterotic magnetic phase.

Here is made a review on the case where double heterojunctions are formed as shown in Fig. 54 by growth of the stellar fractal structure from a plurality of origins. In the temperature range having realizing the phase separation, there is no spin correlation among somatic regions. Once the temperature of the double heterojunctions is lowered, an order is born in the dendritic region, long-distance correlation is generated in the entirety of the somatic/dendritic/somatic regions. Therefore, it has been confirmed that spin correlation between somatic regions can be switched ON and OFF by changing the temperature that is an external parameter.

Bonding of a plurality of regions separated via double heterojunctions can be switched by changing an external parameter (for example, temperature) to derive the functionality and realize a functional device.

Heretofore, some specific embodiments of the invention have been explained. However, the invention is not limited to those embodiments, but contemplates various changes and modifications within the technical concept of the invention.

As described above, according to the invention, by changing the growth condition of a fractal structure with time, it is possible to obtain a fractal structure having a heterojunction made by two regions different in fractal dimension characterizing the self similarity and to modify and control the dimensionality of a material by a design method beyond the conventional simple fractal nature. In such a fractal structure, by adjusting the volume ratio of a plurality of regions, various natures of phase transition appearing in the fractal structure can be controlled. Moreover, by optimization of the fractal dimensions, controllability can be enhanced.

**Claims**

1. A fractal structure comprising:

   at least one heterojunction formed by two regions different in fractal dimension characterizing the self similarity from each other.

2. The fractal structure according to claim 1 wherein the fractal dimensions change step by step from one to another between the two regions forming the heterojunction.

3. The fractal structure according to claim 1 wherein the fractal dimensions change continuously between the two regions forming the heterojunction.

4. The fractal structure according to claim 1 wherein the two regions forming the heterojunction are different in phase.

5. The fractal structure according to claim 1 wherein the two regions forming the heterojunction are in phase separation.

6. The fractal structure according to claim 1 wherein one of the two regions forming the heterojunction exhibits a ferromagnetic phase and the other exhibits a paramagnetic phase.

7. The fractal structure according to claim 1 wherein one of the two regions forming the heterojunction exhibits a metal phase and the other exhibits an insulative phase.

8. The fractal structure according to claim 1 wherein a potential barrier against conduction band electrons is formed along the interface of the heterojunction.

9. The fractal structure according to claim 1 comprising:

   a first region having a first fractal dimension and forming a core; and
   one or more second regions having a second fractal dimension around the first region,

   wherein the second fractal dimension is lower than the first fractal dimension.

10. The fractal structure according to claim 9 wherein the entirety of the first region and the second region has a stellar shape.

11. The fractal structure according to claim 9 satisfying $D_{f1}>2.7$ and $D_{f2}<2.3$ where $D_{f1}$ is the first fractal dimension and $D_{f2}$ is the second fractal dimension.

12. The fractal structure according to claim 9 satisfying $2.7<D_{f1}\leq3$ and $1\leq D_{f2}<2.3$ where $D_{f1}$ is the first fractal dimension and $D_{f2}$ is the second fractal dimension.

13. The fractal structure according to claim 9 satisfying $2.9 \leq D_{f1} \leq 3$ and $1 \leq D_{f2} < 2.3$ where $D_{f1}$ is the first fractal dimension and $D_{f2}$ is the second fractal dimension.

14. The fractal structure according to claim 9 wherein one said second region is interposed between two said first regions to form two heterojunctions.

15. A method of forming a fractal structure having at least one heterojunction formed by two regions different in fractal dimension characterizing the self similarity from each other, comprising:

    growing the fractal structure from one or more origins, and changing the growth condition with time in the growth process such that different fractal dimensions are obtained.

16. The method according to claim 15 wherein the growth is carried out by using a growth condition capable of obtaining a first fractal dimension from the start of the growth to a first point of time and by using a growth condition capable of obtaining a second fractal dimension lower than the first fractal dimension from the first point of time to a second point of time.

17. The method according to claim 16 satisfying $D_{f1} > 2.7$ and $D_{f2} < 2.3$ where $D_{f1}$ is the first fractal dimension and $D_{f2}$ is the second fractal dimension.

18. The method according to claim 16 satisfying $2.7 < D_{f1} \leq 3$ and $1 \leq D_{f2} < 2.3$ where $D_{f1}$ is the first fractal dimension and $D_{f2}$ is the second fractal dimension.

19. The method according to claim 16 satisfying $2.9 \leq D_{f1} \leq 3$ and $1 \leq D_{f2} < 2.3$ where $D_{f1}$ is the first fractal dimension and $D_{f2}$ is the second fractal dimension.

20. A functional material comprising at least as a part thereof:

    a fractal structure having at least one heterojunction formed by two regions different in fractal dimension characterizing the self similarity from each other.

21. The functional material according to claim 20 wherein the two regions forming the heterojunction are different in phase.

22. The functional material according to claim 20 wherein the two regions forming the heterojunction are in phase separation.

23. The functional material according to claim 20 wherein one of the two regions forming the heterojunction exhibits a ferromagnetic phase and the other exhibits a paramagnetic phase.

24. The functional material according to claim 20 wherein one of the two regions forming the heterojunction exhibits a metal phase and the other exhibits an insulative phase.

25. The functional material according to claim 20 wherein a potential barrier against conduction band electrons is formed along the interface of the heterojunction.

26. The functional material according to claim 20 wherein one said second region is interposed between two said first regions to form two heterojunctions.

27. The functional material according to claim 20 wherein the fractal structure includes:

    a first region having a first fractal dimension and forming a core; and
    one or more second regions having a second fractal dimension around the first region,

    wherein the second fractal dimension is lower than the first fractal dimension.

28. The functional material according to claim 27 wherein the entirety of the first region and the second region has a stellar shape.

**29.** The functional material according to claim 27 satisfying $D_{f1}>2.7$ and $D_{f2}<2.3$ where $D_{f1}$ is the first fractal dimension and $D_{f2}$ is the second fractal dimension.

**30.** The functional material according to claim 27 satisfying $2.7<D_{f1}\leq3$ and $1\leq D_{f2}<2.3$ where $D_{f1}$ is the first fractal dimension and $D_{f2}$ is the second fractal dimension.

**31.** The functional material according to claim 27 satisfying $2.9\leq D_{f1}\leq3$ and $1\leq D_{f2}<2.3$ where $D_{f1}$ is the first fractal dimension and $D_{f2}$ is the second fractal dimension.

**32.** A method of forming a functional material including at least as a part thereof a fractal structure having at least one heterojunction formed by two regions different in fractal dimension characterizing the self similarity from each other, comprising:

growing the fractal structure from one or more origins, and changing the growth condition with time in the growth process such that different fractal dimensions are obtained.

**33.** The method according to claim 32 wherein the growth is carried out by using a growth condition capable of obtaining a first fractal dimension from the start of the growth to a first point of time and by using a growth condition capable of obtaining a second fractal dimension lower than the first fractal dimension from the first point of time to a second point of time.

**34.** The method according to claim 33 satisfying $D_{f1}>2.7$ and $D_{f2}<2.3$ where $D_{f1}$ is the first fractal dimension and $D_{f2}$ is the second fractal dimension.

**35.** The method according to claim 33 satisfying $2.7<D_{f1}\leq3$ and $1\leq D_{f2}<2.3$ where $D_{f1}$ is the first fractal dimension and $D_{f2}$ is the second fractal dimension.

**36.** The method according to claim 33 satisfying $2.9\leq D_{f1}\leq3$ and $1\leq D_{f2}<2.3$ where $D_{f1}$ is the first fractal dimension and $D_{f2}$ is the second fractal dimension.

**37.** A functional device using a fractal structure having at least one heterojunction formed by two regions different in fractal dimension characterizing the self similarity from each other.

**38.** The functional device according to claim 37 wherein the two regions forming the heterojunction are different in phase.

**39.** The functional device according to claim 37 wherein the two regions forming the heterojunction are in phase separation.

**40.** The functional device according to claim 37 wherein one of the two regions forming the heterojunction exhibits a ferromagnetic phase and the other exhibits a paramagnetic phase.

**41.** The functional device according to claim 37 wherein one of the two regions forming the heterojunction exhibits a metal phase and the other exhibits an insulative phase.

**42.** The functional device according to claim 37 wherein a potential barrier against conduction band electrons is formed along the interface of the heterojunction.

**43.** The functional device according to claim 37 wherein one said second region is interposed between two said first regions to form two heterojunctions.

**44.** The functional device according to claim 43 wherein physical connection between two said first regions is switched ON and OFF by externally controlling the second region.

**45.** The functional device according to claim 44 wherein the parameter of the control is temperature.

**46.** The functional device according to claim 37 wherein the fractal structure includes:

a first region having a first fractal dimension and forming a core; and
one or more second regions having a second fractal dimension around the first region,

wherein the second fractal dimension is lower than the first fractal dimension.

47. The functional device according to claim 46 wherein the entirety of the first region and the second region has a stellar shape.

48. The functional device according to claim 46 satisfying $D_{f1}>2.7$ and $D_{f2}<2.3$ where $D_{f1}$ is the first fractal dimension and $D_{f2}$ is the second fractal dimension.

49. The functional device according to claim 46 satisfying $2.7<D_{f1}\leq3$ and $1\leq D_{f2}<2.3$ where $D_{f1}$ is the first fractal dimension and $D_{f2}$ is the second fractal dimension.

50. The functional device according to claim 46 satisfying $2.9\leq D_{f1}\leq3$ and $1\leq D_{f2}<2.3$ where $D_{f1}$ is the first fractal dimension and $D_{f2}$ is the second fractal dimension.

51. A method of forming a functional device including at least as a part thereof a fractal structure having at least one heterojunction formed by two regions different in fractal dimension characterizing the self similarity from each other, comprising:

growing the fractal structure from one or more origins, and changing the growth condition with time in the growth process such that different fractal dimensions are obtained.

52. The method according to claim 51 wherein the growth is carried out by using a growth condition capable of obtaining a first fractal dimension from the start of the growth to a first point of time and by using a growth condition capable of obtaining a second fractal dimension lower than the first fractal dimension from the first point of time to a second point of time.

53. The method according to claim 52 satisfying $D_{f1}>2.7$ and $D_{f2}<2.3$ where $D_{f1}$ is the first fractal dimension and $D_{f2}$ is the second fractal dimension.

54. The method according to claim 52 satisfying $2.7<D_{f1}\leq3$ and $1\leq D_{f2}<2.3$ where $D_{f1}$ is the first fractal dimension and $D_{f2}$ is the second fractal dimension.

55. The method according to claim 52 satisfying $2.9\leq D_{f1}\leq3$ and $1\leq D_{f2}<2.3$ where $D_{f1}$ is the first fractal dimension and $D_{f2}$ is the second fractal dimension.

# *Fig. 1*

# Fig. 2

# Fig. 3

# Fig. 4

## Fig. 5

# Fig. 6

# Fig. 7

# Fig. 8

## Fig. 9

## Fig. 10

# *Fig. 11*

# Fig. 12

# Fig. 13

# *Fig. 14*

# *Fig.* 15

# *Fig. 16*

# *Fig. 17*

# Fig. 18

# Fig. 19

# Fig. 20

## Fig. 21

# *Fig. 22*

# Fig. 23

# Fig. 24

# *Fig.  25*

# *Fig. 26*

# Fig. 27

# Fig. 28

## Fig. 29

# Fig. 30

Fig. 31

# Fig. 32

# Fig. 33

# Fig. 34

# *Fig. 35*

# Fig. 36

## *Fig. 37*

# Fig. 38

# Fig. 39

# Fig. 40

# Fig. 41

# Fig. 42

# *Fig.* 43

## *Fig. 44*

# Fig. 45

# Fig. 46

## Fig. 47

# Fig. 48

# Fig. 49

## Fig. 50

# Fig. 51

# Fig. 52

SOMATIC REGION

DENDRITIC REGION

# Fig. 53

# *Fig. 54*

SOMATIC REGION / DENDRITIC REGION / SOMATIC REGION

## Fig. 55

# Fig. 56

# Fig. 57

Fig. 58A

Fig. 58B

Fig. 58C

Fig. 58D

EP 1 415 952 A1

# *Fig. 59*

## Fig. 60

# Fig. 61

# Fig. 62

## Fig. 63

# Fig. 64

# Fig. 65

# Fig. 66

Fig. 67

# Fig. 68

# Fig. 69

# *Fig. 70*

# *Fig. 71*

# Fig. 72

# Fig. 73

# Fig. 74

## INTERNATIONAL SEARCH REPORT

JP/02/07167

| A. | CLASSIFICATION OF SUBJECT MATTER |
|---|---|

Int.Cl$^7$ B82B1/00, B82B3/00, H01L49/00, H01L29/06

According to International Patent Classification (IPC) or to both national classification and IPC

| B. | FIELDS SEARCHED |
|---|---|

Minimum documentation searched (classification system followed by classification symbols)

Int.Cl$^7$ B82B1/00, B82B3/00, H01L49/00, H01L29/06

Documentation searched other than minimum documentation to the extent that such documents are included in the fields searched

| Jitsuyo Shinan Koho | 1922-1996 | Jitsuyo Shinan Toroku Koho | 1996-2002 |
|---|---|---|---|
| Kokai Jitsuyo Shinan Koho | 1971-2002 | Toroku Jitsuyo Shinan Koho | 1994-2002 |

Electronic data base consulted during the international search (name of data base and, where practicable, search terms used)

Web of Science
[fractal* AND [Mott OR Anderson OR ferromag*]]
[fractal* AND hetero*]

| C. | DOCUMENTS CONSIDERED TO BE RELEVANT |
|---|---|

| Category* | Citation of document, with indication, where appropriate, of the relevant passages | Relevant to claim No. |
|---|---|---|
| A | WO 01/29841 A1 (SONY CORP.), 26 April, 2001 (26.04.01), Full text; Figs. 1 to 28 & JP 2001-118379 A | 1-14,20-31, 37-50 |
| | PHYSICS LETTERS A, Vol.277, No.4-5, pages 267 to 272 R. Ugajin, "Composite nanomaterials based on fractal-shaped structures" 04 December, 2000 (04.12.00), | |
| X | *the whole document* | 1-8,15, 20-26,32, 37-45,51 |
| A | *the whole document* | 9-14,16-19, 27-31,33-36, 46-50,52-55 |

| ☒ Further documents are listed in the continuation of Box C. | ☐ See patent family annex. |
|---|---|

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier document but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 02 October, 2002 (02.10.02) | 15 October, 2002 (15.10.02) |

| Name and mailing address of the ISA/ | Authorized officer |
|---|---|
| Japanese Patent Office | |
| Facsimile No. | Telephone No. |

Form PCT/ISA/210 (second sheet) (July 1998)

## INTERNATIONAL SEARCH REPORT

JP/02/07167

| C (Continuation). DOCUMENTS CONSIDERED TO BE RELEVANT | | |
|---|---|---|
| Category* | Citation of document, with indication, where appropriate, of the relevant passages | Relevant to claim No. |
| A | APPLIED PHYSICS LETTERS, Vol.76, No.12, pages 1624 to 1626 R. Ugajin et al., "Growth model of coupled-fractal networks" 20 March, 2000 (20.03.00), *the whole document* | 15-19,32-36, 51-55 |
| P,X | APPLIED PHYSICS LETTERS, Vol.80, No.21, pages 4021 to 4023 R. Ugajin, "Heterotic phase in ferromagnetism of a nerve-cell-like fractal-based complex" 27 May, 2002 (27.05.02), *the whole document* | 1-55 |

Form PCT/ISA/210 (continuation of second sheet) (July 1998)